(19) Europäisches Patentamt
European Patent Office
Office européen des brevets

(11) **EP 3 136 450 B1**

(12) **EUROPEAN PATENT SPECIFICATION**

(45) Date of publication and mention
of the grant of the patent:
**09.06.2021 Bulletin 2021/23**

(51) Int Cl.:
***H01L 51/46*** *(2006.01)*    ***H01L 51/48*** *(2006.01)*

(21) Application number: **15785727.7**

(86) International application number:
**PCT/KR2015/004267**

(22) Date of filing: **28.04.2015**

(87) International publication number:
**WO 2015/167229 (05.11.2015 Gazette 2015/44)**

(54) **PEROVSKITE SOLAR CELL AND MANUFACTURING METHOD THEREFOR**

PEROWSKIT-SOLARZELLE UND HERSTELLUNGSVERFAHREN DAFÜR

CELLULE SOLAIRE EN PEROVSKITE ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.04.2014 KR 20140051078
10.07.2014 KR 20140086581**

(43) Date of publication of application:
**01.03.2017 Bulletin 2017/09**

(73) Proprietors:
• **Research & Business Foundation
Sungkyunkwan
University
Gyeonggi-do 440-746 (KR)**
• **Global Frontier Center for Multiscale
Energy Systems
Seoul 151-015 (KR)**

(72) Inventors:
• **PARK, Nam-Gyu
Seoul 158-759 (KR)**
• **LEE, Jin Wook
Yeongyang-gun
Gyeongsangbuk-do 764-841 (KR)**
• **SEOL, Dong Jin
Seoul 139-752 (KR)**

• **CHO, Anna
Gunpo-si
Gyeonggi-do 435-722 (KR)**

(74) Representative: **Manitz Finsterwald
Patent- und Rechtsanwaltspartnerschaft mbB
Martin-Greif-Strasse 1
80336 München (DE)**

(56) References cited:
**EP-A1- 2 693 503        WO-A1-2013/171520
WO-A1-2016/019124    KR-A- 20130 091 865
KR-A- 20140 003 998    KR-A- 20140 007 045
KR-A- 20140 035 285**

• **GILES E. EPERSON ET AL.: 'Formamidinium lead
trihalide: a broadly tunable perovskite for
efficient plannar heterojunction solar cells'
ENERGY ENVIRON. SCI. vol. 7, 2014, pages 982
- 988, XP055234624**
• **Ziyong Cheng ET AL: "Layered organic-inorganic
hybrid perovskites: structure, optical properties,
film preparation, patterning and templating
engineering", CrystEngComm, vol. 12, no. 10, 1
January 2010 (2010-01-01), page 2646,
XP55045568, ISSN: 1466-8033, DOI:
10.1039/c001929a**

## Description

### TECHNICAL FIELD

The invention relates to a Perovskite solar cell and a method of preparing the Perovskite solar cell. A Perovskite solar cell according to the preamble of claim 1 and a method of preparing a Perovskite solar cell according to the preamble of claim 7 are known from EP 2 693 503 A1.

### BACKGROUND

A organic-inorganic hybrid Perovskite was first applied to a solar cell by Tsutomu Miyasaka's group in 2009 in Japan (J. Am. Chem. Soc. 2009, 131, 6050-6051), and has recently attracted a lot of attention as a light absorbing material for a solar cell due to its high absorption coefficient and property that can be easily synthesized through a solution process.

After the present research team first published a solid hole conductor-based Perovskite solar cell with a photovoltaic conversion efficiency of 9.7% in 2012 (Sci. Rep. 2012, 2:579, 1-7), numerous follow-up studies have been conducted.

Most of Perovskite photoactive layers researched so far are $CH_3NH_3PbI_3$ and $CH_3NH_3PbI_{3-x}Cl_x$.

The excellent photovoltaic performance of such a methylammonium lead halide Perovskite is derived from its long-range charge transport property and high light absorbing property. The absorption coefficient of $CH_3NH_3PbI_3$ is about one order of magnitude higher than that of molecular sensitizers such as ruthenium bipyridyl complex. Further, $CH_3NH_3PbI_3$ and $CH_3NH_3PbI_{3-x}Cl_x$ can transport electrons and holes when $CH_3NH_3PbI_3$ has diffusion lengths of about 130 nm for an electron and about 100 nm for a hole and $CH_3NH_3PbI_{3-x}Cl_x$ has diffusion lengths of about 1,069 nm for an electron and about 1,213 nm for a hole.

The balanced electron and hole transport properties of $CH_3NH_3PbX_3$ (X=I or I-Cl) form a Perovskite which is a solar cell with a planar heterojunction structure.

Charge accumulation capability of $CH_3NH_3PbI_3$ Perovskite has been reported, which supports generation of free charge carriers and a resultant high open circuit voltage close to about 1.1 V.

Triiodide and the mixed methylammonium lead halide Perovskites are stabilized in a tetragonal phase at room temperature, which have a band gap of about 1.5 eV.

Assuming that there is no loss of incident light caused by reflection from a transparent conductive substrate, a maximum photocurrent density is theoretically about 27.2 mA/cm$^2$ and an absorption onset wavelength measured from an incident photovoltaic conversion efficiency (IPCE) is about 800 nm. However, it is necessary to consider the occurrence of light loss of from about 15% to about 20% in an actual apparatus, and in this case the photocurrent density is from about 23.1 mA/cm$^2$ to about 21.8 mA/cm$^2$. Therefore, a methylammonium lead halide-based Perovskite cell may have a PCE of about 20% when a voltage of about 1.1 V and a fill factor of about 0.8 are satisfied.

However, the methylammonium cation-based organic-inorganic hybrid Perovskite has a band gap of about 1.55 eV and can absorb a light having a wavelength of up to about 800 nm, and thus production amount of photocurrent is limited to about 21 mA/cm$^2$. Further, for a conventional methylammonium cation-based organic-inorganic hybrid Perovskite solar cell, hysteresis is caused by an external voltage, and, thus, it is difficult to precisely measure photovoltaic properties. Furthermore, the conventional methylammonium cation-based organic-inorganic hybrid Perovskite solar cell undergoes a reversible phase transition between tetragonal and cubic symmetry at a temperature between about 300 K and about 400 K corresponding to an operation temperature of the solar cell, and such a structural phase transition is expected to involve a change of a band structure and may affect the photovoltaic properties.

Therefore, a Perovskite which is not affected by a phase transition is demanded. Further, a Perovskite with a low band gap is demanded to further improve a PCE.

A formamidinium cation-based Perovskite was reported as an alternative material to the conventional methylammonium cation-based Perovskite solar cell having the above-described problems [Inorg. Chem. 2013, 52, 9019-9038].

However, when the formamidinium cation-based Perovskite is actually applied to a solar cell, it was reported that the maximum efficiency was about 14.2% and an average efficiency was about 9% using a p-i-n junction structure [Energy Environ. Sci., 2014, 7, p982-988].

### DISCLOSURE OF THE INVENTION

### PROBLEMS TO BE SOLVED BY THE INVENTION

Accordingly, it is an object of the invention to provide a Perovskite solar cell and a method of preparing the Perovskite solar cell which overcome the above problems.

However, problems to be solved by the present disclosure are not limited to the above-described problems, and although not described herein, other problems to be solved by the present disclosure can be clearly understood by those skilled in the art from the following descriptions.

## MEANS FOR SOLVING THE PROBLEMS

The object of the invention is satisfied by a Perovskite solar cell according to claim 1 and by a method of preparing a Perovskite solar cell according to claim 7.

In accordance with claim 1, there is provided a Perovskite solar cell, including: a first electrode including a transparent conductive substrate; a recombination-preventing layer formed on the first electrode; a photoactive layer formed on the recombination-preventing layer; a hole transport layer formed on the photoactive layer; and a second electrode formed on the hole transport layer, wherein the photoactive layer consists of a Perovskite double layer consisting of a layer of a first Perovskite represented by the following Chemical Formula 1 and a layer of a second Perovskite represented by the following Chemical Formula 2 formed on the layer of the first Perovskite:

$$[\text{Chemical Formula 1}] \quad RMX_3,$$

in Chemical Formula 1, R includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof, M includes a +2 metal cation selected from the group consisting of $Pb^{2+}$, $Sn^{2+}$, $Ge^{2+}$, and combinations thereof, and X is a halogen anion;

$$[\text{Chemical Formula 2}] \quad R'M'X'_3,$$

in Chemical Formula 2, R' includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof, M' includes a +2 metal cation selected from the group consisting of $Pb^{2+}$, $Sn^{2+}$, $Ge^{2+}$, and combinations thereof, and X' is a halogen anion; and wherein the cation R included in the Chemical Formula 1 and the cation R' included in the Chemical Formula 2 are different from each other and the metal cation M' is the same as M.

In accordance with claim 7, there is provided a method of preparing a Perovskite solar cell, including: forming a recombination-preventing layer on a first electrode including a transparent conductive substrate; forming a photoactive layer on the recombination-preventing layer; forming a hole transport layer on the photoactive layer; and forming a second electrode on the hole transport layer, wherein the forming of the photoactive layer includes coating a solution containing a first Perovskite represented by the following Chemical Formula 1 on the recombination-preventing layer to form a layer of the first Perovskite and coating a solution containing a precursor R'X' for preparing a second Perovskite on the layer of the first Perovskite to form a layer of the second Perovskite represented by the following Chemical Formula 2 so as to form a Perovskite double layer consisting of the layer of the first Perovskite and the layer of the second Perovskite:

$$[\text{Chemical Formula 1}] \quad RMX_3,$$

in Chemical Formula 1, R includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof, M includes a +2 metal cation selected from the group consisting of $Pb^{2+}$, $Sn^{2+}$, $Ge^{2+}$, and combinations thereof, and X is a halogen anion;

$$[\text{Chemical Formula 2}] \quad R'M'X'_3,$$

in Chemical Formula 2, R' includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof, M' includes a +2 metal cation selected from the group consisting of $Pb^{2+}$, $Sn^{2+}$, $Ge^{2+}$, and combinations thereof, and X' is a halogen anion; wherein the forming of the Perovskite double layer, after forming the layer of the first Perovskite by coating the solution containing the first Perovskite on the recombination-preventing layer, includes coating the solution containing the precursor R'X' for preparing the second Perovskite on the layer of the first Perovskite to replace the cation R included in the first Perovskite with the cation R' included in the precursor for preparing the second Perovskite so as to form the layer of the second Perovskite on the layer of the first Perovskite, and wherein further the cation R included in the Chemical Formula 1 and the cation R' included in the Chemical Formula 2 are different from each other and the metal cation M' is the same as M.

## EFFECTS OF THE INVENTION

According to an exemplary embodiment of the present disclosure, by forming a Perovskite double layer consisting of a $HC(NH_2)_2PbI_3$ Perovskite layer and a $CH_3NH_3PbI_3$ Perovskite layer as a photoactive layer, the $CH_3NH_3PbI_3$ Perovskite layer can be formed to be increased in absorption coefficient in a range of from about 700 nm to about 750 nm as compared with a case of using only the $HC(NH_2)_2PbI_3$ Perovskite layer as a photoactive layer, and, thus, it is possible to increase absorbance in the above-described range and thus possible to improve a photocurrent of a solar cell.

Further, by forming the Perovskite double layer consisting of the $HC(NH_2)_2PbI_3$ Perovskite layer and the $CH_3NH_3PbI_3$ Perovskite layer as a photoactive layer, it is possible to reduce defects on a surface of the $HC(NH_2)_2PbI_3$ Perovskite layer and thus possible to improve a voltage of a solar cell.

Furthermore, it is possible to remove a pin hole which is generated in case of forming a $HC(NH_2)_2PbI_3$ Perovskite layer on a porous semiconductor layer and thus also possible to improve a photovoltage of a solar cell.

## BRIEF DESCRIPTION OF THE DRAWINGS

FIG. 1A and FIG. 1B illustrate a structure of a Perovskite solar cell in accordance with an exemplary embodiment of the present disclosure.

FIG. 2A to FIG. 2C are images of precursor powder for Perovskite solar cell obtained in accordance with an example of the present disclosure and a comparative example.

FIG. 3 is a H NMR spectrum of a precursor for solar cell prepared by a synthesis method in accordance with an example of the present disclosure.

FIG. 4 is a H NMR spectrum of a precursor for solar cell prepared by a synthesis method in accordance with Comparative Example 1.

FIG. 5 is a H NMR spectrum of a precursor for solar cell prepared by a synthesis method in accordance with Comparative Example 2.

FIG. 6A to FIG. 6F show light absorption properties of a Perovskite solar cell in accordance with an example of the present disclosure.

FIG. 7A to FIG. 7E show X-ray diffraction patterns depending on a temperature in accordance with an example of the present disclosure.

FIG. 8A to FIG. 8F show photovoltaic effects depending on an annealing duration time at about 150°C in accordance with an example of the present disclosure.

FIG. 9A to FIG. 9E show photovoltaic effects depending on a thickness of a $TiO_2$-containing semiconductor layer in accordance with an example of the present disclosure.

FIG. 10A to FIG. 10F are SEM images showing an upper part of a photoactive layer formed on a $TiO_2$-containing semiconductor layer in accordance with an example of the present disclosure.

FIG. 11A and FIG. 11B show the dependence of IPCE depending on a thickness of a $TiO_2$-containing semiconductor layer in accordance with an example of the present disclosure.

FIG. 12A to FIG. 12F show effects depending on a content of a polymer present in $TiO_2$ paste in accordance with an example of the present disclosure.

FIG. 13 shows an effect depending on a content of a polymer present in $TiO_2$ paste in accordance with an example of the present disclosure.

FIG. 14 shows a photocurrent-voltage curve of a solar cell including $HC(NH_2)_2PbI_3$ Perovskite in accordance with an example of the present disclosure.

FIG. 15A and FIG. 15B are electron microscopic images showing surfaces of a $HC(NH_2)_2PbI_3$ Perovskite layer and a $HC(NH_2)_2PbI_3$/ $CH_3NH_3PbI_3$ double layer formed on porous $TiO_2$ layers, respectively, in accordance with an example of the present disclosure.

FIG. 16 shows absorption spectra of FTO/recombination blocking layer (BL), FTO/BL/FAPbI$_3$, and FTO/BL/FAPbI$_3$/thin-MAPbI$_3$ in accordance with an example of the present disclosure.

FIG. 17A to FIG. 17C show current-voltage curves, IPCE spectra, and an external quantum efficiency graph of FAPbI$_3$, MAPbI$_3$, and a FAPbI$_3$/MAPbI$_3$ double layer in accordance with an example of the present disclosure.

FIG. 18 shows a current-voltage curve of a Perovskite solar cell including a FAPbI$_3$/MAPbI$_3$ double layer in accordance with an example of the present disclosure.

FIG. 19 shows a photocurrent-voltage curve depending on a scan direction in accordance with an example of the present disclosure.

FIG. 20A and FIG. 20B show the dependence of a current-voltage curve on the number of scanning in FAPbI$_3$ and MAPbI$_3$-based Perovskite solar cells, respectively, in accordance with an example of the present disclosure.

**FIG. 21** is a graph showing a differential scanning calorimetry analysis on FAPbI$_3$ in accordance with an example of the present disclosure.

## BEST MODE FOR CARRYING OUT THE INVENTION

Hereinafter, embodiments and examples of the present disclosure will be described in detail with reference to the accompanying drawings so that the present disclosure may be readily implemented by those skilled in the art. In drawings, parts irrelevant to the description are omitted for the simplicity of explanation, and like reference numerals denote like parts through the whole document.

Through the whole document, the term "connected to" or "coupled to" that is used to designate a connection or coupling of one element to another element includes both a case that an element is "directly connected or coupled to" another element and a case that an element is "electronically connected or coupled to" another element via still another element.

Through the whole document, the term "on" that is used to designate a position of one element with respect to another element includes both a case that the one element is adjacent to the another element and a case that any other element exists between these two elements.

Further, through the whole document, the term "comprises or includes" and/or "comprising or including" used in the document means that one or more other components, steps, operation and/or existence or addition of elements are not excluded in addition to the described components, steps, operation and/or elements unless context dictates otherwise. Through the whole document, the term "about or approximately" or "substantially" are intended to have meanings close to numerical values or ranges specified with an allowable error and intended to prevent accurate or absolute numerical values disclosed for understanding of the present disclosure from being illegally or unfairly used by any unconscionable third party. Through the whole document, the term "step of" does not mean "step for".

Through the whole document, the term "combination of" included in Markush type description means mixture or combination of one or more components, steps, operations and/or elements selected from a group consisting of components, steps, operation and/or elements described in Markush type and thereby means that the disclosure includes one or more components, steps, operations and/or elements selected from the Markush group.

Through the whole document, a phrase in the form "A and/or B" means "A or B, or A and B".

Through the whole document, a "Perovskite" has an ABX$_3$ structure, and the ABX$_3$ structure can be readily estimated based on a tolerance factor t:

$$t = (r_A + r_X)/[2^{1/2}(r_B + r_X)]$$

Herein, $r_A$ and $r_B$ are effective ionic radiuses of cations in a cubo-octahedral A-site and an octahedral B-site, respectively, and $r_X$ is a radius of an anion.

Hereinafter, exemplary embodiments and examples of the present disclosure will be described in detail with reference to the accompanying drawings.

In accordance with a first aspect of the present disclosure, there is provided a Perovskite solar cell according to claim 1. The Perovskite solar cell according to claim 1 comprises: a first electrode including a transparent conductive substrate; a recombination-preventing layer formed on the first electrode; a photoactive layer formed on the recombination-preventing layer; a hole transport layer formed on the photoactive layer; and a second electrode formed on the hole transport layer, wherein the photoactive layer consists of a Perovskite double layer consisting of a layer of a first Perovskite represented by the following Chemical Formula 1 and a layer of a second Perovskite represented by the following Chemical Formula 2 formed on the layer of the first Perovskite:

[Chemical Formula 1]      RMX$_3$,

in Chemical Formula 1, R includes a +1 cation selected from the group consisting of C$_n$H$_{2n+1}$NH$_3$$^+$ wherein n is an integer of from 1 to 9, NH$_4$$^+$, HC(NH$_2$)$_2$$^+$, Cs$^+$, NF$_4$$^+$, NCl$_4$$^+$, PF$_4$$^+$, PCl$_4$$^+$, CH$_3$PH$_3$$^+$, CH$_3$AsH$_3$$^+$, CH$_3$SbH$_3$$^+$, PH$_4$$^+$, AsH$_4$$^+$, SbH$_4$$^+$, and combinations thereof, M includes a +2 metal cation selected from the group consisting of Pb$^{2+}$, Sn$^{2+}$, Ge$^{2+}$, and combinations thereof, and X is a halogen anion;

[Chemical Formula 2]      R'M'X'$_3$,

in Chemical Formula 2, R' includes a +1 cation selected from the group consisting of C$_n$H$_{2n+1}$NH$_3$$^+$ wherein n is an integer of from 1 to 9, NH$_4$$^+$, HC(NH$_2$)$_2$$^+$, Cs$^+$, NF$_4$$^+$, NCl$_4$$^+$, PF$_4$$^+$, PCl$_4$$^+$, CH$_3$PH$_3$$^+$, CH$_3$AsH$_3$$^+$, CH$_3$SbH$_3$$^+$, PH$_4$$^+$, AsH$_4$$^+$, SbH$_4$$^+$, and combinations thereof, M' includes a +2 metal cation selected from the group consisting of Pb$^{2+}$, Sn$^{2+}$, Ge$^{2+}$,

and combinations thereof, and X' is a halogen anion; and the cation R included in the Chemical Formula 1 and the cation R' included in the Chemical Formula 2 are different from each other and the metal cations M' and M are the same.

In Chemical Formula 1 or Chemical Formula 2, Rand/or R' may include a linear or branched, saturated or unsaturated alkyl group having 1 to 20 carbon atoms, and may include, for example, methyl, ethyl, propyl, butyl, pentyl, hexyl, heptyl, octyl, nonyl, decyl, or all available isomers thereof.

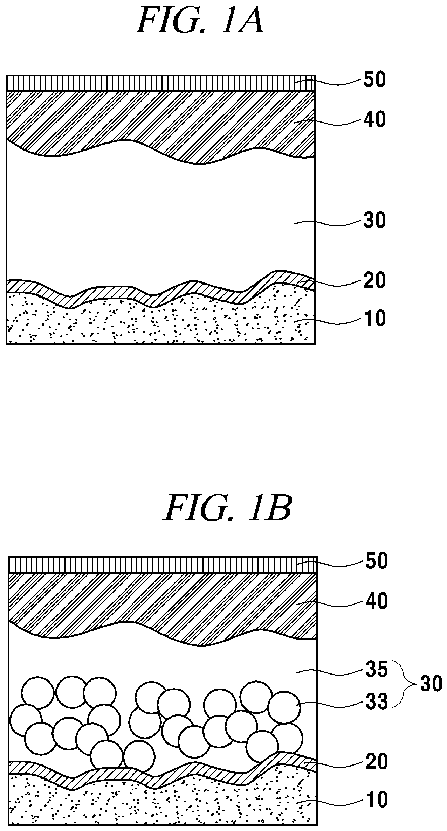

In this regard, FIG. 1A and FIG. 1B are schematic diagrams illustrating a layer structure of a Perovskite solar cell in accordance with an exemplary embodiment of the present disclosure.

Referring to FIG. 1A, in accordance with an exemplary embodiment of the present disclosure, a Perovskite solar cell of the present disclosure may have a sandwich structure in which two electrodes, i.e., a first electrode 10 and a second electrode 50, are in surface contact with each other. For example, the first electrode 10 may be represented as a working electrode or a semiconductor electrode, and the second electrode 50 may be represented as a counter electrode.

In accordance with the invention, a recombination-preventing layer 20 is formed on the first electrode, and a photoactive layer 30 is formed on the recombination-preventing layer 20 and wherein the photoactive layer 30 consists of a Perovskite double layer consisting of a layer 35 of a first Perovskite represented by the following Chemical Formula 1 and a layer 37 of a second Perovskite represented by the following Chemical Formula 2 formed on the layer 35 of the first Perovskite.

In accordance with an exemplary embodiment of the present invention, the photoactive layer may consist of the Perovskite double layer consisting of the layer 35 of the first Perovskite including $HC(NH_2)_2PbI_3$ and the layer 37 of the second Perovskite including $CH_3NH_3PbI_3$.

In accordance with an exemplary embodiment of the present disclosure, the Perovskite $RMX_3$ structure can be readily estimated based on a tolerance factor t: $t = (r_R + r_X)/[2^{1/2}(r_M + r_X)]$. Herein, $r_R$ and $r_M$ are effective ionic radiuses of cations in a cubo-octahedral R-site and an octahedral M-site, respectively, and $r_X$ is a radius of an anion. A radius of a cation from RPbl3 was calculated in the range of from 164 pm for t = 0.8 to 259 pm for t = 1 based on $Pb^{2+}$ = 119 pm and I = 220 pm. For example, a $CH_3NH_3^+$ cation has an ionic radius of 180 pm and thus is suitable for a Perovskite structure. A change of a cation may result in a change in Pb-I bond length and/or bond angle, which may cause a change in band structure and band gap tuning. Substitution of slightly larger formamidinium $[HC(NH_2)_2^+]$ and methylammonium $(CH_3NH_3^+)$ can be stabilized as a trigonal Perovskite structure (black) or a hexagonal non-Perovskite structure (yellow). A band gap of $HC(NH_2)_2PbI_3$ was estimated at 1.45 eV lower than that of $CH_3NH_3PbI_3$(1.52 eV) due to lowered symmetry. Therefore, it is expected that $HC(NH_2)_2PbI_3$ absorbs light in a wider range than $CH_3NH_3PbI_3$ due to its lower band gap, and, thus, it is expected that $HC(NH_2)_2PbI_3$ has a higher PCE due to a higher photocurrent. Further, a remarkable phase transition in an operation temperature range of a solar cell is not expected. According to a conventional study, it was found that dry crystals (a-phase) of black $HC(NH_2)_2PbI_3$ are converted into β-phase at about 200 K or less and converted into γ-phase at about 130 K or less.

However, in a Perovskite solar cell, $HC(NH_2)_2PbI_3$ shows a low PCE of 4.3% with an unexpectedly very low photocurrent density of 6.45 mA/cm2, and in this case, the low photocurrent can be explained as being caused by non-uniformity in conduction band edge between $TiO_2$ and $HC(NH_2)_2PbI_3$ . Since it was confirmed that a scaffold layer including an electron non-injected oxide such as $Al_2O_3$ or $ZrO_2$ is easily operated in a Perovskite solar cell, it may not be a reason for explaining the photocurrent.

A hole transport layer (hole transport material, hereinafter, also referred to as "HTM") 40 is formed on the photoactive layer 30, and the second electrode 50 may be formed on the hole transport layer 40. The hole transport layer 40 may be formed in order to reduce the oxidized photoactive layer 30.

In accordance with an exemplary embodiment of the present disclosure, the transparent conductive substrate may include a glass substrate or a plastic substrate containing a material selected from the group consisting of indium tin oxide (ITO), fluorine tin oxide (FTO), $ZnO-Ga_2O_3$, $ZnO-Al_2O_3$, tin-based oxide, zinc oxide, and combinations thereof. The transparent conductive substrate may use any material without particular limitations as long as it has conductance and transparency. For example, the plastic substrate may include a member selected from the group consisting of polyethylene terephthalate, polyethylene naphthalate, polycarbonate, polypropylene, polyimide, triacetyl cellulose, and combinations thereof.

In accordance with the invention, in the Perovskite double layer, after forming the layer of the first Perovskite on the recombination-preventing layer, the layer of the second Perovskite is formed on the layer of the first Perovskite by coating a solution containing a precursor R'X' for preparing the second Perovskite on the layer of the first Perovskite to replace the cation R included in the first Perovskite by the cation R' included in the precursor for preparing the second Perovskite so as to form the layer of the second Perovskite on the layer of the first Perovskite, wherein the cation R included in the Chemical Formula 1 and the cation R' included in the Chemical Formula 2 are different from each other and the metal cation M' is the same as M.

In accordance with an exemplary embodiment of the present disclosure, the cation R included in the first Perovskite may include formamidinium ion, and the cation R' included in the second Perovskite may include methylammonium cation. For example, the layer of the first Perovskite may include $HC(NH_2)_2PbI_3$ and the layer of the second Perovskite may include $CH_3NH_3PbI_3$.

In accordance with an exemplary embodiment of the present disclosure, the Perovskite double layer including the $HC(NH_2)_2PbI_3$ Perovskite layer and the $CH_3NH_3PbI_3$ Perovskite layer may be formed by, after forming the $HC(NH_2)_2PbI_3$ Perovskite layer by coating the $HC(NH_2)_2PbI_3$ Perovskite on the recombination-preventing layer, coating a $CH_3NH_3I$-containing solution on the $HC(NH_2)_2PbI_3$ Perovskite layer to replace a formamidinium cation included in the $HC(NH_2)_2PbI_3$ by a methylammonium cation included in the $CH_3NH_3I$ so as to form the $CH_3NH_3PbI_3$ Perovskite layer on the $HC(NH_2)_2PbI_3$ Perovskite layer.

In accordance with an exemplary embodiment of the present disclosure, the layer of the first Perovskite may have a thickness of about 1 $\mu$m or less. For example, the layer of the first Perovskite may have a thickness of about 1 $\mu$m or less, about 900 nm or less, about 800 nm or less, about 700 nm or less, about 600 nm or less, about 500 nm or less, about 400 nm or less, about 300 nm or less, about 200 nm or less, or about 100 nm or less, and desirably about 300 nm or less.

In accordance with an exemplary embodiment of the present disclosure, the layer of the second Perovskite may have a thickness of about 300 nm or less. For example, the layer of the second Perovskite may have a thickness of about 300 nm or less, about 200 nm or less, about 100 nm or less, about 50 nm or less, about 10 nm or less, about 8 nm or less, about 6 nm or less, about 4 nm or less, about 2 nm or less, or about 1 nm or less, and desirably about 10 nm or less. For example, if the thickness of the layer of the second Perovskite is greater than the thickness of the layer of the first Perovskite, a light absorption region may be changed from about 840 nm which is an absorption region of the first Perovskite to about 800 nm which is an absorption region of the second Perovskite, which may cause a current loss.

In accordance with an exemplary embodiment of the present disclosure, the photoactive layer 30 may further include a semiconductor layer 33 as an electron transport layer, as illustrated in FIG. 1B. For example, after the semiconductor layer 33 is formed on the recombination-preventing layer 20, the layer 35 of the first Perovskite and the layer 37 of the second Perovskite may be formed on the semiconductor layer 33.

In accordance with an exemplary embodiment of the present disclosure, the semiconductor layer 33 may have a thickness of about 1 $\mu$m or less. For example, the semiconductor layer 33 may have a thickness of about 1 $\mu$m or less, about 900 nm or less, about 800 nm or less, about 700 nm or less, about 600 nm or less, about 500 nm or less, about 400 nm or less, about 300 nm or less, about 200 nm or less, or about 100 nm or less, and desirably about 300 nm or less. In accordance with an exemplary embodiment of the present disclosure, the semiconductor layer may have a thickness equal to or smaller than that of the layer 35 of the first Perovskite. For example, the semiconductor layer 33 may be included in the layer 35 of the first Perovskite as illustrated in FIG. **1B,** or it may be formed as a structure that the first Perovskite infiltrates into pores of the semiconductor layer 33 having a mesoporous structure.

In accordance with an exemplary embodiment of the present disclosure, the semiconductor layer 33 may have a porous structure including pores of from about 20 nm to about 500 nm. For example, the semiconductor layer 33 may have a mesoporous structure including pores of from about 20 nm to about 500 nm. For example, the semiconductor layer 33 may include pores of from about 20 nm to about 500 nm, from about 20 nm to about 450 nm, from about 20 nm to about 400 nm, from about 20 nm to about 350 nm, from about 20 nm to about 300 nm, from about 20 nm to about 250 nm, from about 20 nm to about 200 nm, from about 20 nm to about 150 nm, from about 20 nm to about 100 nm, or from about 20 nm to about 50 nm. For example, the pores of the semiconductor layer may be formed using a polymer as a sacrificial material for forming pores. The polymer sacrificial material may include a polymer selected from the group consisting of ethylene cellulose, hydroxypropylcellulose, polyethyleneglycol, polyethyleneoxide, polyvinylalcohol, polyvinylpyrrolidone, and combinations thereof.

In accordance with an exemplary embodiment of the present disclosure, the semiconductor layer may include an organic semiconductor, an inorganic semiconductor, or mixture thereof.

In accordance with an exemplary embodiment of the present disclosure, the semiconductor layer may include metal oxide selected from the group consisting of $TiO_2$, $SnO_2$, $ZnO$, $WO_3$, $Nb_2O_5$, $TiSrO_3$, and combinations thereof.

In accordance with an exemplary embodiment of the present disclosure, the hole transport layer 40 may include a unimolecular or polymeric hole transport material. For example, spiro-MeOTAD [2,2',7,7'-tetrakis(N,N-p-dimethoxyphenylamino)-9,9'-spirobifluorene] may be used as the unimolecular hole transport material and P3HT[poly(3-hexylthiophene)] may be used as the polymeric hole transport material. Further, for example, the hole transport layer 40 may use a dopant selected from the group consisting of Li-based dopants, Co-based dopants, and combinations thereof. For example, a mixture of spiro-MeOTAD, tBP, and Li-TFSI may be used as the hole transport material.

In accordance with an exemplary embodiment of the present disclosure, the second electrode may include a member selected from the group consisting of Pt, Au, Ni, Cu, Ag, In, Ru, Pd, Rh, Ir, Os, C, conductive polymers, and combinations thereof. For example, highly stable gold (Au) may be used as the second electrode to improve the long-term stability of the Perovskite solar cell of the present disclosure.

In a Perovskite solar cell, a $CH_3NH_3PbI_3$ Perovskite conventionally used as a Perovskite photoactive layer has a band gap of about 1.55 eV and absorbs a light having a wavelength range of up to about 800 nm. The $CH_3NH_3PbI_3$ Perovskite has a narrow absorption range but has an excellent absorbance in a long wavelength range. A $HC(NH_2)_2PbI_3$ Perovskite used to make it easy to absorb a light in a broader range than the $CH_3NH_3PbI_3$ Perovskite has a band gap of about 1.47 eV and absorbs a light having a wavelength range of up to about 840 nm, but has a relatively lower absorption coefficient in a long wavelength range (from about 750 nm to about 800 nm) than the $CH_3NH_3PbI_3$ Perovskite and thus has a low absorbance in the long wavelength range. In accordance with an exemplary embodiment of the present disclosure, a double layer including the $CH_3NH_3PbI_3$ Perovskite and the $HC(NH_2)_2PbI_3$ Perovskite was formed in order to use the advantages of the $CH_3NH_3PbI_3$ Perovskite and the $HC(NH_2)_2PbI_3$ Perovskite.

In accordance with a second aspect of the present disclosure, there is provided a method of preparing a Perovskite solar cell according to claim 7.

Since the second aspect of the present disclosure relates to a method of preparing the Perovskite solar cell in accordance with the first aspect of the present disclosure, detailed descriptions of the method of preparing the Perovskite solar cell, which overlap with those of the first aspect of the present disclosure, are omitted hereinafter, but the descriptions of the first aspect of the present disclosure may be identically applied to the second aspect of the present disclosure, even though they are omitted hereinafter.

In accordance with an exemplary embodiment of the present disclosure, the cation R included in the first Perovskite may include formamidinium ion and the cation R' included in the second perovskite may include methylammonium cation. In accordance with an exemplary embodiment of the present disclosure, forming a Perovskite double layer including a layer of a $HC(NH_2)_2MX_3$ Perovskite and a layer of a $CH_3NH_3M'X'_3$ Perovskite may include, after forming the layer of the $HC(NH_2)_2MX_3$ Perovskite by coating the $HC(NH_2)_2MX_3$ Perovskite on the recombination-preventing layer, coating a $CH_3NH_3M'X'_3$-containing solution on the layer of the $HC(NH_2)_2MX_3$ Perovskite to replace the formamidinium cation included in the $HC(NH_2)_2MX_3$ by the methylammonium cation included in the $CH_3NH_3M'X'_3$ so as to form the layer of the $CH_3NH_3M'X'_3$ Perovskite on the layer of the $HC(NH_2)_2MX_3$ Perovskite.

In accordance with an exemplary embodiment of the present disclosure, the semiconductor layer having the mesoporous structure may be formed by forming and coating a mixture including metal oxide semiconductor nanoparticles and a polymer as a sacrificial material for forming pores and then forming pores by removing the polymer. In accordance with an exemplary embodiment of the present disclosure, a pore size of the semiconductor layer may be regulated by regulating a content of the polymer included in the semiconductor layer.

In accordance with an exemplary embodiment of the present disclosure, the forming of a photoactive layer may further include, after forming the Perovskite double layer including the layer of the first Perovskite and the layer of the second Perovskite, annealing the photoactive layer including the Perovskite double layer at from 100°C to 170°C. In accordance with an exemplary embodiment of the present disclosure, the method may further include annealing the photoactive layer further including the semiconductor layer at from 100°C to 170°C. In accordance with an exemplary embodiment of the present disclosure, the method may further include, after forming the photoactive layer including the semiconductor layer and the Perovskite double layer, annealing the photoactive layer including the semiconductor layer and the Perovskite double layer at from 100°C to 170°C. For example, the annealing may be performed at from about 100°C to about 170°C, from about 100°C to about 160°C, from about 100°C to about 150°C, from about 100°C to about 140°C, from about 100°C to about 130°C, from about 100°C to about 120°C, from about 100°C to about 110°C, from about 110°C to about 170°C, from about 110°C to about 160°C, from about 110°C to about 150°C, from about 110°C to about 140°C, from about 110°C to about 130°C, from about 110°C to about 120°C, from about 120°C to about 170°C, from about 120°C to about 160°C, from about 120°C to about 150°C, from about 120°C to about 140°C, from about 120°C to about 130°C, from about 130°C to about 170°C, from about 130°C to about 160°C, from about 130°C to about 150°C, from about 130°C to about 140°C, from about 140°C to about 170°C, from about 140°C to about 160°C, from about 140°C to about 150°C, from about 150°C to about 170°C, from about 150°C to about 160°C, or from about 160°C to about 170°C.

**Mode for Carrying out the Invention**

Hereinafter, examples of the present disclosure will be described in more detail.

[Examples]

1. Preparation of precursor $HC(NH_2)_2I$ for Perovskite

In order to prepare the Perovskite solar cell in accordance with the first aspect of the present disclosure, formamidinium iodide [$HC(NH_2)_2I$] as a precursor for Perovskite solar cell was prepared first.

Firstly, 0.1 mol NaH (TCI, 60 wt%) was put into 100 mL ethanol solution (Samchun, 99.99%) to synthesize 0.1 mol sodium ethoxide solution, as shown in the following Reaction Formula 1:

$$NaH + C_2H_5OH \rightarrow NAOC_2H_5 + H_2 (\uparrow) \qquad (1).$$

Then, the sodium ethoxide solution was put into a round flask and 0.1 mol HC(NH)(NH$_2$). HCl (TCI, >95%) was added thereto with stirring, as shown in the following Reaction Formula 2:

$$HC(NH)(NH_2). HCl + NaOC_2H_5 \rightarrow HC(NH)(NH_2) + NaCl (\downarrow) + C_2H_5OH \qquad (2).$$

Then, a precipitate NaCl as a by-product was filtered using a filter paper. C$_2$H$_5$OH as another by-product was easily removed by evaporation. After putting the solution obtained by the filtering into a round flask and filling a bath with ice and water, the round flask was placed in the bath such that at least half of the flask was immersed therein.

Finally, 0.1 mol hydroiodic acid (HI) (Aldrich, 57 wt% in water) was added in a drop-wise manner to the solution with stirring, as shown in the following Reaction Formula 3:

$$HC(NH)(NH_2) + HI \rightarrow HC(NH_2)_2I \qquad (3).$$

After the dropping of the HI, a reaction was carried out for 2 hours, and all the solvent was removed at 60°C using a rotary evaporator.

In a state where all the solvent was removed, diethyl ether was added thereto such that all the product was immersed therein, and after stirring for 20 minutes, a process of removing the solution was repeated 5 times.

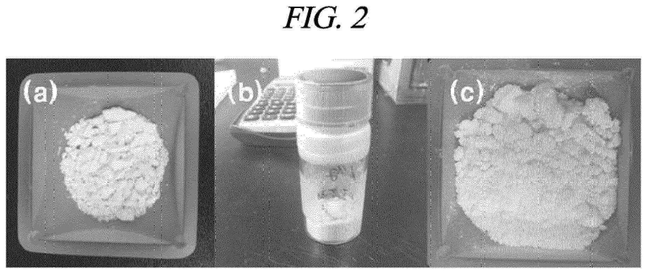

After the washing process, HC(NH$_2$)$_2$I was filtered and then dried in a vacuum for 12 hours to obtain a precursor HC(NH$_2$)$_2$I in the form of white powder as shown in FIG. 2A.

The method of synthesizing a precursor HC(NH$_2$)$_2$I in accordance with the present Example is different from a conventional method using formamidine acetate and HI in which acetic acid as a by-product is not easily removed from HC(NH$_2$)$_2$I. Since the precipitate NaCl in Reaction Formula 2 has a much lower solubility in ethanol, ethanol was used instead of methanol in the present Example (0.65 g NaCl/1 kg of ethanol vs 14 g NaCl/1 kg of methanol).

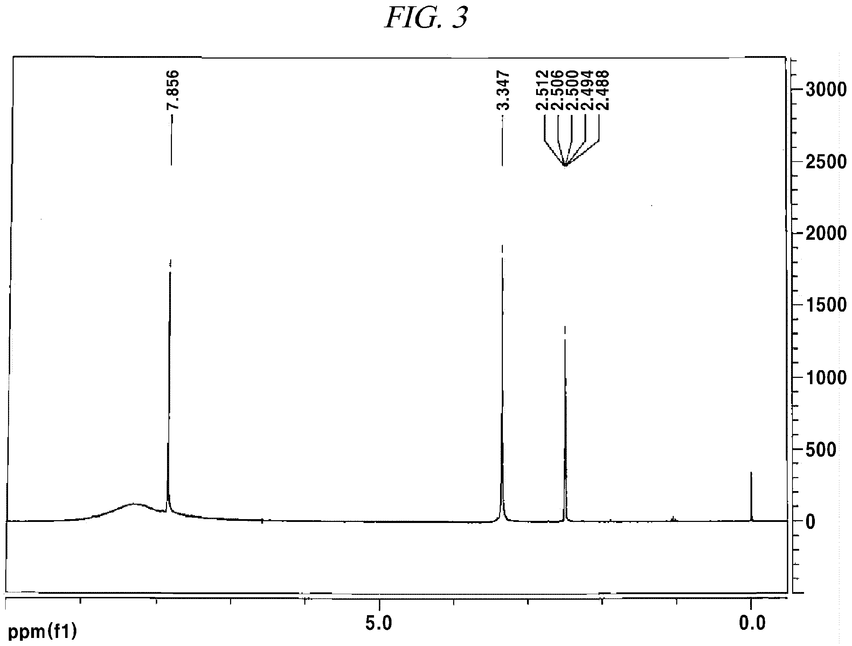

The purity of the precursor HC(NH$_2$)$_2$I synthesized according to the present Example was confirmed by $^1$H NMR and high resolution mass spectroscopy as shown in FIG. 3.

The yield of the HC(NH$_2$)$_2$I was 90% or more.

$^1$H NMR(300 MHz, DMSO) d 7.857 (s, 1H), 8.314 (br, 4H).

The high resolution mass spectroscopy (HRMS)(FAB) calculated as shown below: CH$_5$IN$_2$ Na [M+Na]$^+$: 194.9390, found: 194.9395.

2. Preparation of an exemplary Perovskite HC(NH$_2$)$_2$PbI$_3$/ CH$_3$NH$_3$PbI$_3$ solar cell according to the invention

In order to prepare the Perovskite solar cell in accordance with the first aspect of the present disclosure, a first electrode including a transparent conductive substrate was first produced, and the recombination-preventing layer was formed on the first electrode, and a porous semiconductor/Perovskite complex layer including the porous semiconductor layer and the Perovskite double layer was formed on the recombination-preventing layer.

First, a fluorine-doped tin oxide-coated (FTO) glass (Pilkington, TEC-8, 8 Ω/sq) was washed by UV-ozone treatment for 15 minutes and consecutively washed with detergent and ethanol.

A dense TiO$_2$ blocking layer (BL) as the recombination-preventing layer was formed by spin-coating a 0.15 M titanium diisopropoxide bis(acetylacetonate (Aldrich, 75 wt% in isopropanol) solution in 1-butanol (Aldrich, 99.8%) and annealing at 500°C for 15 minutes.

A porous TiO$_2$ film was deposited on the dense TiO$_2$ blocking layer by spin-coating TiO$_2$ paste diluted in ethanol.

The TiO$_2$ paste was prepared by mixing hydrothermally synthesized TiO$_2$ nanoparticles of 50 nm, ethyl cellulose (EC) in terpineol (TP), and lauric acid (LA) (nominal ratio of TiO$_2$:TP:EC:LA = 1.25:6:0.6~1.5:0.1).

The content of the EC was varied from 0.6 to 1.5 in order to control a pore size and porosity.

The content of the paste was varied from 0.8 g to 2 g in 10 ml ethanol in order to control the thickness of the film.

0.8 g of the TiO$_2$ paste in 10 mL ethanol resulted in 130 nm, and 2 g of the TiO$_2$ paste resulted in 320 nm.

The rate of increase in thickness was about 160 nm/g TiO$_2$.

The TiO$_2$ paste-coated electrode was annealed at 550°C for 1 hour.

The electrode was cooled to room temperature and then immersed in a 20 mM TiCl$_4$ (Aldrich, >98%) aqueous solution at 70°C for 10 minutes and washed with deionized water and then annealed at 500°C for 30.

HC(NH$_2$)$_2$PbI$_3$ was formed on the porous TiO$_2$ film by a two-step method using the formamidinium iodide and PbI$_2$ available in the market.

4 mmol (1.844 g) PbI$_2$ (Aldrich, 99%) was dissolved in 4 mL $N,N$-dimethylformamide (DMF) (Sigma-Aldrich, 99.8%) with stirring at 70°C.

30 µL of the PbI$_2$ solution was rotated on the porous TiO$_2$ film at 500 rpm for 5 seconds and at 6,000 rpm for 20 seconds.

The PbI$_2$-coated TiO$_2$ film was dried at 40°C for 3 minutes and at 100°C for 10 minutes.

In order to prepare HC(NH$_2$)$_2$PbI$_3$, the Pbl2-coated TiO$_2$ film was immersed for 1 minute in a 0.01 g/mL HC(NH$_2$)$_2$I solution in 2-propanol (Sigma-Aldrich, 99.5%) and rotated at 500 rpm for 5 seconds, at 1,500 rpm for 10 seconds, and at 3,000 rpm for 20 seconds, and then dried at 40°C for 3 minutes and at 150 °C for 15 minutes.

After the immersion in the HC(NH$_2$)$_2$I, a rotation process was performed in order to uniformly dry the film.

In order to remove the excess HC(NH$_2$)$_2$I which was not reacted, the film was immersed in the 2-propanol solution for 15 minutes to be washed and then dried at 150°C for 5 minutes.

In order to increase an absorption at a long wavelength, a thin CH$_3$NH$_3$PbI$_3$ layer having a thickness of 10 nm or less was formed on a HC(NH$_2$)$_2$PbI$_3$ layer having a thickness of 300 nm, and 20 µL of 0.01 g/mL CH$_3$NH$_3$I solution in 2-propanol was dropped to a HC(NH$_2$)$_2$PbI$_3$-coated electrode being rotated at 6,000 rpm and then the electrode was dried on a hot plate at 100°C for 10 minutes. Through this process, formamidinium cation included in the HC(NH$_2$)$_2$PbI$_3$ was replaced by methylammonium cation included in the CH$_3$NH$_3$I on the upper parts of the HC(NH$_2$)$_2$PbI$_3$ layer, so that the CH$_3$NH$_3$PbI$_3$ Perovskite layer was formed as an overlayer on the HC(NH$_2$)$_2$PbI$_3$ Perovskite layer.

The electrode was washed with 2-propanol and then dried on a hot plate at 100°C for 5 minutes.

A solution for spiro-MeOTAD coating was prepared by dissolving 72.3 mg spiro-MeOTAD in 1 mL chlorobenzene, and 28.8 µL 4-tert-butyl pyridine and 17.5 µL lithium bis(trifluoromethanesulfonyl)imide] solution [520 mg Li-TFSI in 1 mL acetonitrile (Sigma-Aldrich, 99.8%)] were added thereto.

The spiro-MeOTAD was deposited at 4,000 rpm for 20 seconds.

Finally, as a counter electrode, gold was thermally evaporated at an evaporation rate of 1 Å/s.

**[Comparative Example 1]**

Preparation of precursor HC(NH$_2$)$_2$I

**A** precursor HC(NH$_2$)$_2$I was prepared using HC(NH)(NH$_2$), HCl and methanol as shown in the following Formula 4.

$$HC(NH)(NH_2). \ HCl + NaOCH_3 \rightarrow HC(NH)(NH_2) + NaCl \ (\downarrow) + CH_3OH \qquad (4)$$

After NaCl precipitate was filtered using a filter paper, all the solvent was removed in a vacuum at 60°C.

In order to obtain a solution in which the HC(NH)(NH$_2$) prepared by the above-described process was dissolved in ethanol, the HC(NH)(NH$_2$) was dissolved again in ethanol in a state where all the solvent was removed, and then, the process of filtering NaCl precipitate using a filter paper was performed once again.

Then, HI was reacted with the HC(NH)(NH$_2$), so that HC(NH$_2$)$_2$I in the form of yellow powder as shown in **FIG. 2B** was prepared with a yield of from 10% to 20%.

**[Comparative Example 2]**

Preparation of precursor HC(NH$_2$)$_2$I

A precursor HC(NH$_2$)$_2$I in the form of white powder as shown in FIG. 2C was prepared with a yield of 80% using HC(NH)(NH$_2$), HI, and acetic acid as shown in the following Formula 5:

$$HC(NH_2)(NH). \ CH_3COOH + HI \rightarrow HC(NH_2)_2I + CH_3COOH \qquad (5).$$

A Perovskite solar cell was prepared in the same manner as Example using the HC(NH$_2$)$_2$I prepared according to the synthesis method of Comparative Example 2.

**[Comparative Example 3]**

HC(NH$_2$)PbI$_3$ Perovskite solar cell

The above-described HC(NH$_2$)$_2$PbI$_3$/CH$_3$NH$_3$PbI$_3$ Perovskite solar cell was a solar cell including a Perovskite double layer including a HC(NH$_2$)$_2$PbI$_3$ Perovskite layer and a CH$_3$NH$_3$PbI$_3$ Perovskite layer as a photoactive layer.

In order to compare with this, a solar cell including a layer of a Perovskite formamidinium lead iodide [HC(NH$_2$)$_2$PbI$_3$, hereinafter, also referred to as "FAPbI$_3$"] as a photoactive layer was prepared as Comparative Example 3. The rest of the structure except the photoactive layer was the same as that of the Perovskite solar cell of Example 1.

**[Comparative Example 4]**

CH$_3$NH$_3$PbI$_3$ Perovskite solar cell

The above-described HC(NH$_2$)$_2$PbI$_3$/CH$_3$NH$_3$PbI$_3$ Perovskite solar cell was a solar cell including a Perovskite double layer including a HC(NH$_2$)$_2$PbI$_3$ Perovskite layer and a CH$_3$NH$_3$PbI$_3$ Perovskite layer as a photoactive layer.

In order to compare with this, a solar cell including a layer of a Perovskite methylammonium lead iodide [CH$_3$NH$_3$PbI$_3$, hereinafter, also referred to as "MAPbI3"] as a photoactive layer was prepared as Comparative Example 4. The rest of the structure except the photoactive layer was the same as that of the Perovskite solar cell of Example 1.

Analysis of material properties

A $^1$H nuclear magnetic resonance (NMR) spectrum was recorded on a Varian Unity Inova 300 MHz spectrometer using a chemical shift relative to a solvent peak as an internal reference of $^1$H NMR dimethyl sulfoxide (DMSO, $\delta$ 2.5 ppm).

The high resolution mass spectroscopy (HRMS) was recorded according to a fast atom bombardment (FAB) method using a JEOLJMS-700 MStation.

An absorption coefficient was measured according to a conventional method.

In order to measure a transmittance and a reflectance, a HC(NH$_2$)$_2$PbI$_3$ film was used on a dense TiO$_2$-coated FTO glass.

For comparison, an absorption coefficient of a CH$_3$NH$_3$PbI$_3$ film was also checked.

The transmission and the reflectance were measured by a UV-vis spectrophotometer (Perkin Elmer, lamda 35) using an integrating sphere and a dense TiO$_2$-coated FTO glass as a blank for measurement of transmittance.

While a light was incident into the FTO glass in order to measure an absorbance, a light was incident into the Perovskite film in order to measure an absorption coefficient.

X-ray diffraction patterns were collected by a Bruker AXS (D8 advance, Bruker Corporation) using Cu K$\alpha$ radiation at a scan rate of 4°/min.

Morphology of surface and cross section was obtained by a scanning electron microscope (SEM, JSM-7600F, JEOL).

Heat flow depending on a temperature was measured using a differential scanning calorimeter (DSC, Seico Inst., DSC7020 model).

Analysis of photovoltaic properties

A current and a voltage were measured using a Keithley 2400 source meter under one sun illumination (AM 1.5G, 100 mW/cm$^2$) and simulated by a solar simulator (Oriel Sol3A class AAA) equipped with a 450 W Xenon lamp (Newport 6279NS).

The intensity of light was regulated by a NREL-calibrated Si solar cell equipped with a KG-2 filter.

During the measurement, the device was covered with a metal aperture mask.

An incident photon-to-electron conversion efficiency (IPCE) was measured by a specially designed IPCE system (PV measurement Inc.).

A monochromatic beam was generated from a 75 W Xenon lamp (USHIO, Japan).

IPCE data were collected in a DC mode without bias light.

Time-limited photocurrent response was monitored using a 550 nm monochromatic beam at 4 Hz.

Property comparison between precursors HC(NH$_2$)$_2$I prepared in Example and Comparative Examples 1 and 2 (not claimed by the invention)

In the precursor HC(NH$_2$)$_2$I in accordance with Example, a broad NH$_2$ peak and a sharp CH peak were observed around 8.5 and 7.8 as shown in FIG. 3, and the other peaks were dimethylsulfoxide (hereinafter, also referred to as "DMSO") used as a solvent for the NMR measurement and water present in the solvent.

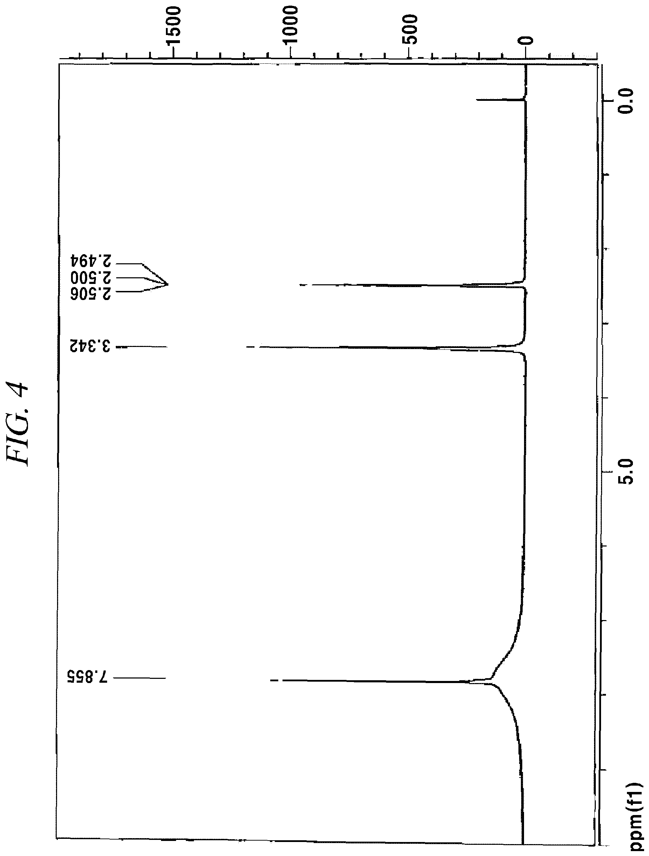

In the precursor HC(NH$_2$)$_2$I in accordance with Comparative Example 1, a broad NH$_2$ peak and a sharp CH peak were observed around 7.855 as shown in FIG. 4, and the two peaks were overlapped. The other peaks were DMSO used as a solvent for the H NMR measurement and water present in the solvent. Although not detected in the H NMR spectrum, it could be seen that the precursor powder HC(NH$_2$)$_2$I was remarkably different in color from those of Example and Comparative Example 2. In case of preparing a Perovskite solar cell using the precursor HC(NH$_2$)$_2$I synthesized in accordance with Comparative Example 2, a Perovskite structure was not well formed, and, thus, it was difficult to evaluate properties as a device, and it was considered that this was because while the methanol was evaporated in preparing the precursor $HC(NH_2)_2I$, a reactant was also evaporated and the reactant was reacted with NaCl.

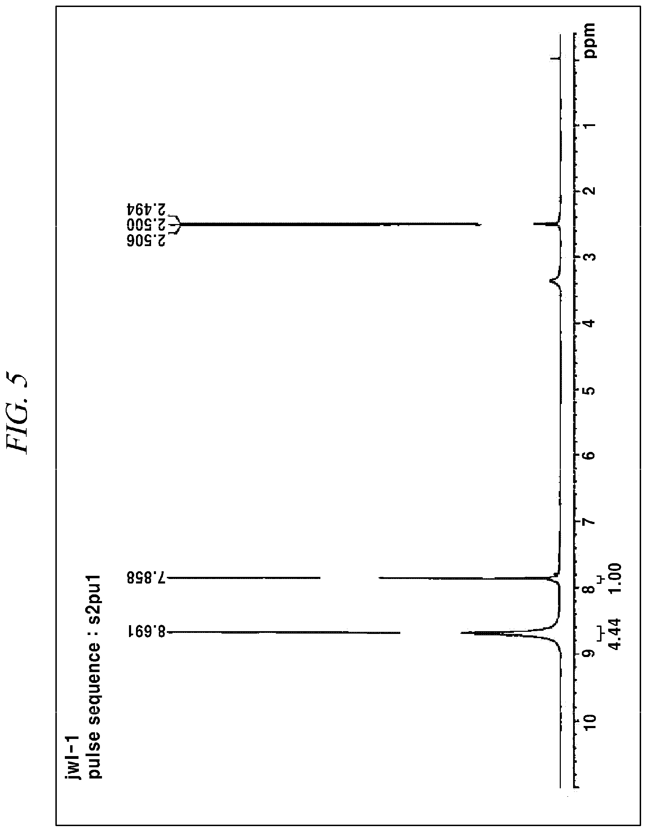

In the precursor $HC(NH_2)_2I$ in accordance with Comparative Example 2, a broad $NH_2$ peak and a sharp CH peak were observed around 9 and 7.855 as shown in FIG. 5, and the other peaks were DMSO used as a solvent for the NMR measurement and water present in the solvent.

Comparison in performance of $HC(NH_2)PbI_3$ solar cell depending on synthesis method of precursor $HC(NH_2)_2I$ (not claimed by the invention)

The energy conversion efficiency of a Perovskite solar cell prepared using the precursor $HC(NH_2)_2I$ in accordance with Example and a Perovskite solar cell prepared using the precursor $HC(NH_2)_2I$ in accordance with Comparative Example 2 was confirmed

Photocurrent density ($J_{sc}$), photovoltage ($V_{OC}$), fill factor (FF), and efficiency of the Perovskite solar cell prepared in accordance with Example were measured 13 times, and the results thereof were as listed in the following Table 1:

[Table 1]

| Example | $J_{sc}$ (mA/cm$^2$) | $V_{OC}$ (V) | FF | Efficiency (%) |
|---|---|---|---|---|
| 1 | 19.43 | 1.055 | 0.71 | 14.52 |
| 2 | 19.47 | 1.055 | 0.71 | 14.59 |
| 3 | 18.77 | 1.047 | 0.7 | 13.79 |
| 4 | 19.05 | 1.038 | 0.67 | 13.26 |
| 5 | 19.03 | 1.048 | 0.66 | 13.22 |
| 6 | 18.93 | 1.038 | 0.65 | 12.83 |
| 7 | 19.27 | 1.051 | 0.67 | 13.55 |
| 8 | 19.12 | 1.064 | 0.67 | 13.61 |
| 9 | 18.49 | 1.058 | 0.68 | 13.29 |
| 10 | 19.23 | 1.029 | 0.66 | 13.08 |
| 11 | 19.37 | 1.043 | 0.71 | 14.25 |
| 12 | 19.48 | 1.033 | 0.71 | 14.28 |
| 13 | 19.72 | 1.034 | 0.68 | 13.79 |
| Average | 19.18 | 1.05 | 0.68 | 13.7 |
| Standard deviation | 0.33 | 0.01 | 0.02 | 0.57 |

Photocurrent density ($J_{SC}$), photovoltage ($V_{OC}$), fill factor (FF), and efficiency of the Perovskite solar cell prepared in accordance with Comparative Example 2 were measured 11 times, and the results thereof were as listed in the following Table 2:

[Table 2]

| Comparative Example 2 | $J_{SC}$ (mA/cm$^2$) | $V_{OC}$ (V) | FF | Efficiency (%) |
|---|---|---|---|---|
| 1 | 17.94 | 0.988 | 0.68 | 11.97 |
| 2 | 17.91 | 0.973 | 0.69 | 12.04 |
| 3 | 18.14 | 0.963 | 0.72 | 12.53 |
| 4 | 17.74 | 1.016 | 0.65 | 11.72 |
| 5 | 17.86 | 1.005 | 0.66 | 11.82 |
| 6 | 17.93 | 1.01 | 0.64 | 11.67 |
| 7 | 17.97 | 1.006 | 0.64 | 11.58 |

(continued)

| Comparative Example 2 | $J_{SC}$ (mA/cm$^2$) | $V_{OC}$ (V) | FF | Efficiency (%) |
|---|---|---|---|---|
| 8 | 17.18 | 1.031 | 0.63 | 11.18 |
| 9 | 17.14 | 1.035 | 0.65 | 11.51 |
| 10 | 18.99 | 0.981 | 0.64 | 11.94 |
| 11 | 18.91 | 0.992 | 0.66 | 12.44 |
| Average | 17.97 | 1 | 0.66 | 11.85 |
| Standard deviation | 0.58 | 0.02 | 0.03 | 0.39 |

By comparison between Table 1 and Table 2, it could be seen that the efficiency of the Perovskite solar cell in accordance with Example was superior. Although not detected in the NMR spectrum of **FIG. 5,** acetic acid chemically bonded to the precursor $HC(NH_2)_2I$ could remain in case of using Comparative Example 2, and it was considered that this was because when the precursor $HC(NH_2)_2I$ was prepared in Comparative Example 2, acetic acid generated as a by-product had the boiling point of 118°C and had the same polarity as the precursor $HC(NH_2)_2I$, and, thus, it was not easy to completely remove the acetic acid.

[Verification of properties of Perovskite solar cell including precursor $HC(NH_2)_2I$ prepared in accordance with Examples]

Absorption by photoactive layer (not claimed by the invention)

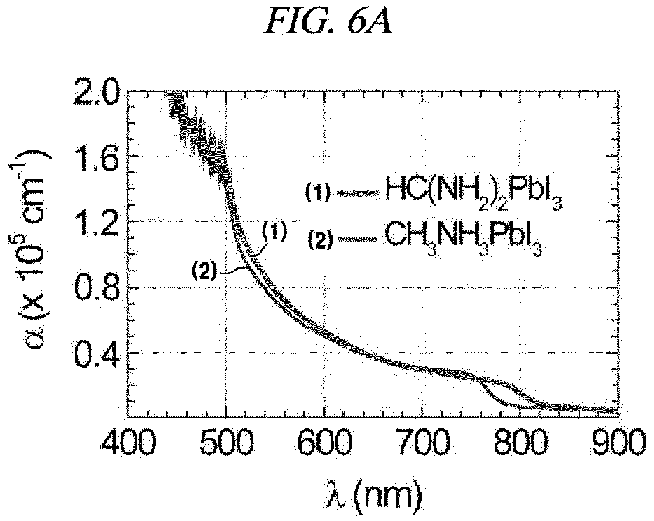

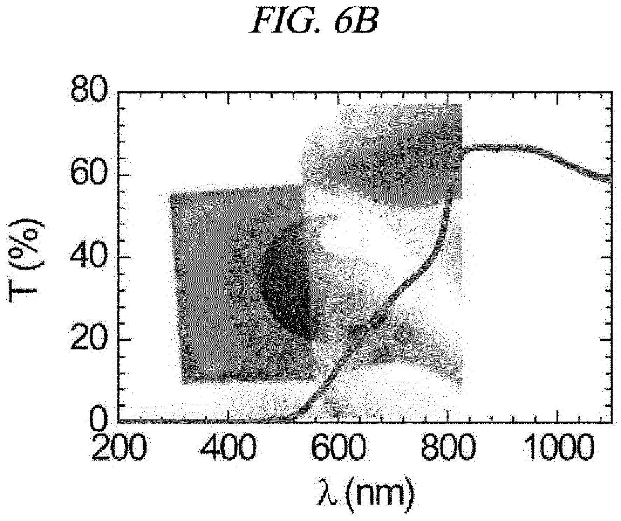

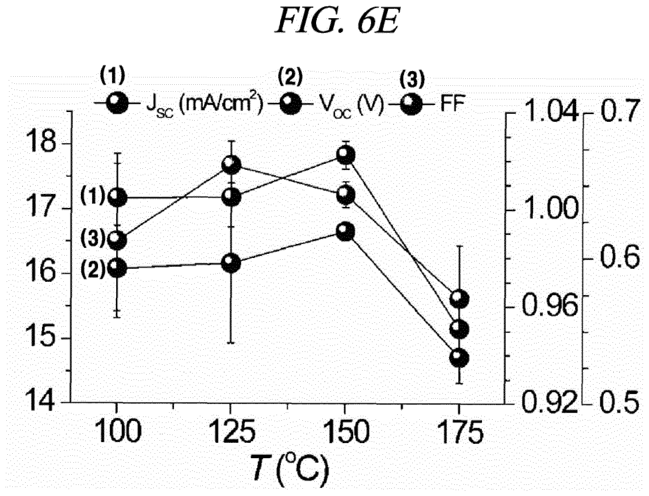

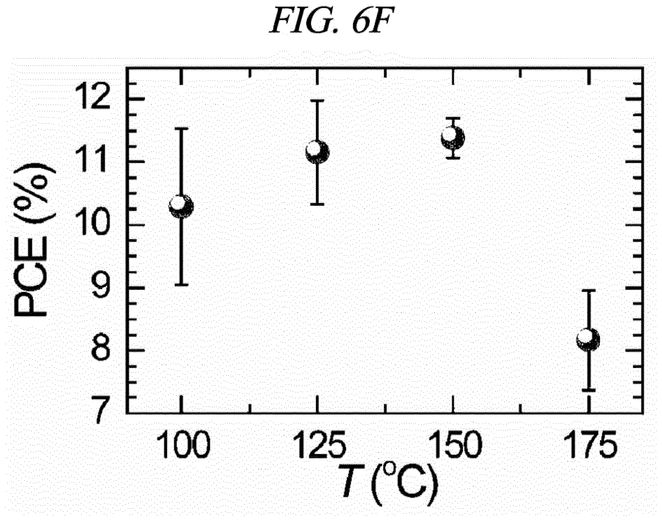

The absorption coefficient of a thickness of a 250 nm-$HC(NH_2)_2PbI_3$ (hereinafter, also referred to as "FAPbI$_3$") film prepared in accordance with the present Example was $1.53 \times 10^5$ cm$^{-1}$ at 500 nm, $0.53 \times 10^5$ cm$^{-1}$ at 600 nm, and $0.30 \times 10^5$ cm$^{-1}$ at 700 nm **(FIG. 6A),** and measured using a formula reported in other studies.
The absorption coefficient of the FAPbI$_3$ at a given wavelength was slightly higher than that of $CH_3NH_3PbI_3$ (hereinafter, also referred to as "MAPbI$_3$") which has been conventionally studied.
A FAPbI$_3$-coated 200 nm-$TiO_2$ film (total thickness: about 300 nm) was transparent brown as shown in **FIG. 6B.**
The overall transmittance after 840 nm showed that band gap absorption corresponding to energy of about 1.47 eV occurred around 840 nm, which is identical to the previous observation.
An increase in transmittance from 600 nm to 840 nm implies loss of light reflection at a long wavelength.

Annealing temperature dependence of photoactive layer (not claimed by the invention)

A photocurrent-voltage characteristic depending on a heat treatment temperature for the porous semiconductor/ $HC(NH_2)_2PbI_3$ Perovskite complex layer of the Perovskite solar cell including the precursor $HC(NH_2)_2I$ prepared in accordance with the present Example and an external quantum efficiency corresponding to each device were measured.
The annealing temperature dependence of the deposited FAPbI$_3$ layer as a photovoltaic performance was shown in **FIG. 6A** to **FIG. 6F.**
Table 3 shows photocurrent density ($J_{SC}$), photovoltage ($V_{OC}$), fill factor (FF), and photo-to-electron conversion efficiency of the $HC(NH_2)_2PbI_3$ Perovskite solar cell depending on a heat treatment temperature. The efficiency was observed to be highest in case of performing a heat treatment at 150°C, which was considered as being caused by a high current density resulting from a high quantum conversion efficiency.

[Table 3]

| Temperature | $J_{SC}$ (mA/cm$^2$) | $V_{OC}$ (V) | FF | Efficiency (%) |
|---|---|---|---|---|
| 100°C | 17.21 | 0.989 | 0.66 | 11.2 |
| 125°C | 17.35 | 0.996 | 0.66 | 11.32 |
| 150°C | 17.96 | 0.991 | 0.64 | 11.47 |
| 175°C | 15.73 | 0.943 | 0.55 | 8.17 |

**The** most superior PCE was obtained at 150°C mainly because of the highest photocurrent density (Jsc) and photovoltage ($V_{OC}$).

The annealing temperature dependence of $J_{SC}$ has a tendency similar to a change in $V_{OC}$ depending on a temperature, which seems to be probably caused by a relationship $V_{OC} = (k_B T/q)\ln(J_{SC}/J_0+1)$.

Accordingly, the PCE is increased along an increase in annealing temperature from 100°C to 150°C and then sharply decreased at 175°C.

The measurement of X-ray diffraction was conducted in order to find out the basis for strong dependence of the photovoltaic performance on an annealing temperature.

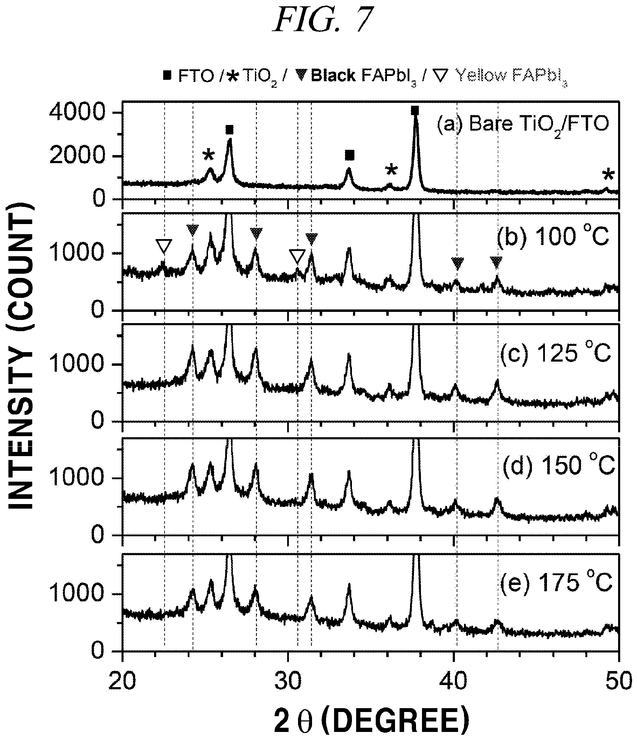

XRD reflection at 24.26°, 28.04°, 31.42°, 40.1°, and 42.7° **(FIG. 7A** to **FIG. 7E)** was indexed to (202), (220), (222), (400), and (330) reflections each corresponding to a black $FAPbI_3$ polymorph.

In a sample annealed at 100°C, a yellow polymorph coexisted with a black polymorph and disappeared in a higher annealing temperature condition.

According to all of data from experiments and simulations using black $FAPbI_3$, the (220) and (222) reflections were stronger than the (202) reflection.

In a sample in accordance with the present Example, the intensity of the (202) reflection was almost similar to those of the (202) and (222) reflections, which shows that preferred orientation of the $FAPbI_3$ layer of the present disclosure is different from the reported result.

Decomposition of the $FAPbI_3$ was not observed in the temperature range of from 100°C to 175°C, which is connected to no heat transfer in the above-described temperature range measured using a differential scanning calorimeter (DSC) (of which data are not illustrated).

In connection with decomposition of the $FAPbI_3$, color bleaching was observed in a sample heat-treated at 200°C.

An effect of a duration at a given annealing temperature on the photovoltaic performance was checked.

When a duration at 150°C was increased from 10 minutes to 15 minutes, $J_{SC}$ was slightly increased with almost no change in $V_{OC}$ and fill factor (FF).

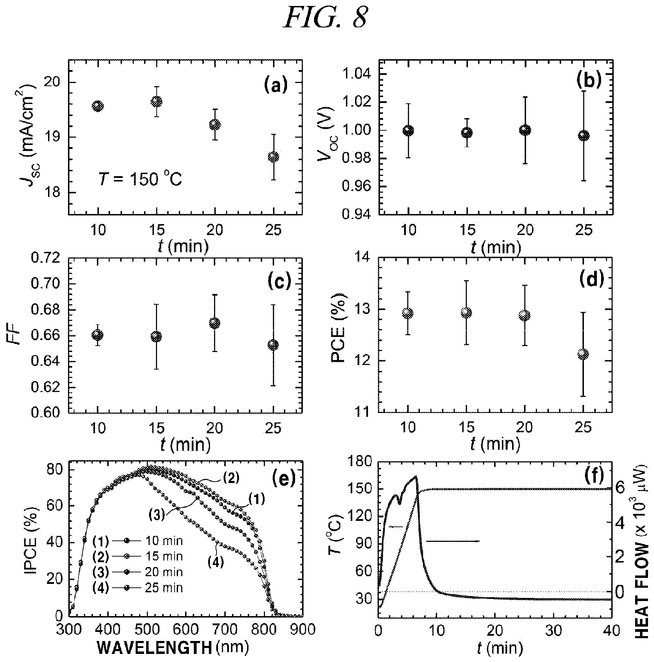

Accordingly, the PCE was slightly higher in the 15 min-heat treatment **(FIG. 8A** to **FIG. 8F).**

However, the PCE was decreased when the duration was increased from 15 minutes to 20 minutes and 25 minutes, and this is because of a decrease in $J_{SC}$ connected to IPCE which is usually low at a long wavelength.

The deterioration of performance in a long time-heat treatment at 150°C is connected to partial decomposition of the $FAPbI_3$ as indicated by a negative heat flow in a DSC analysis (FIG. 8F).

A heating condition for DSC measurement is not exactly identical to that for preparation of a Perovskite sample, but it is clear that crystallization is completed within 15 minutes.

The most superior performance was obtained from the heat treatment of the $FAPbI_3$ at 150°C, and, thus, parameters were further optimized for 150°C-15 min-annealed $FAPbI_3$.

Effect of porous -$TiO_2$ film on morphology of photoactive layer (not claimed by the invention)

As the effects of a porous $TiO_2$ film on the morphology of the deposited $FAPbI_3$, charge collection kinetics and photovoltaic performance were checked.

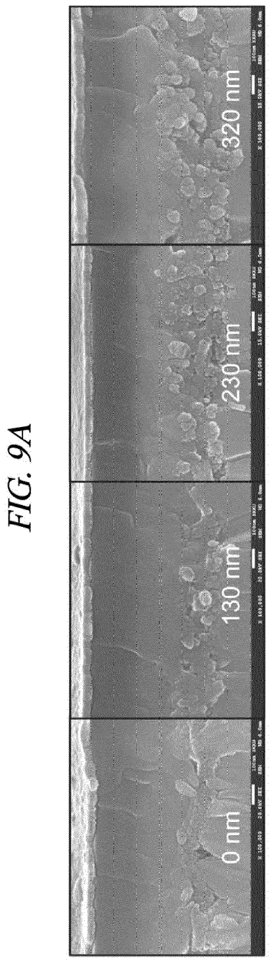

As shown in **FIG. 9A,** $FAPbI_3$ having a thickness of about 300 nm was formed on a dense wall layer, and $FAPbI_3$ was formed to a similar thickness on 130 nm- and 230 nm-porous $TiO_2$ films, but $FAPbI_3$ was formed to a slightly increased thickness on a 320 nm-$TiO_2$ film.

The pores of the porous $TiO_2$ films were entirely filled with $FAPbI_3$, and upper parts of the deposited $FAPbI_3$ layers appear flat.

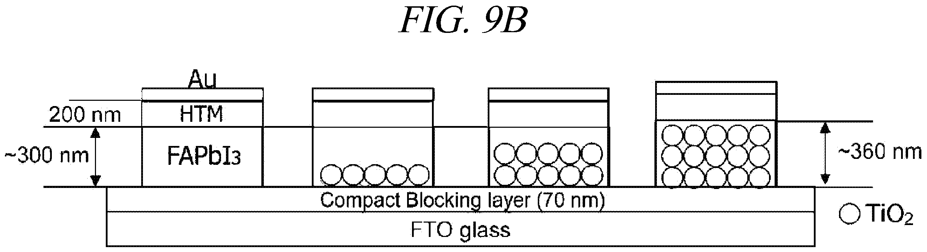

**FIG. 9B** schematically illustrates structures of the layers.

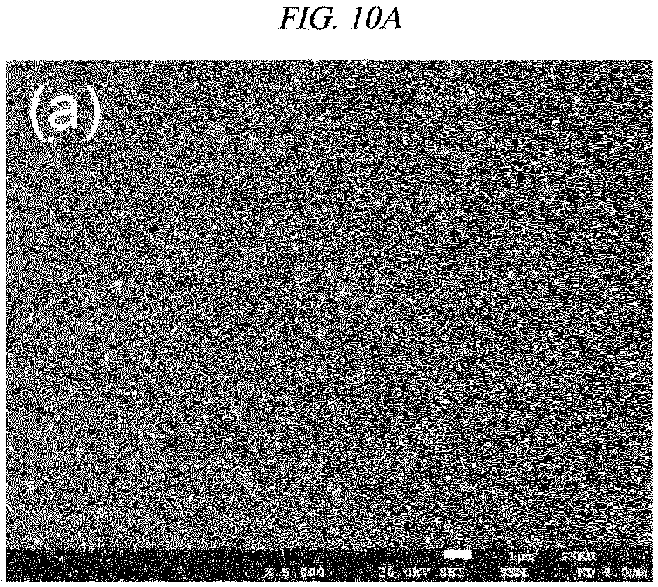

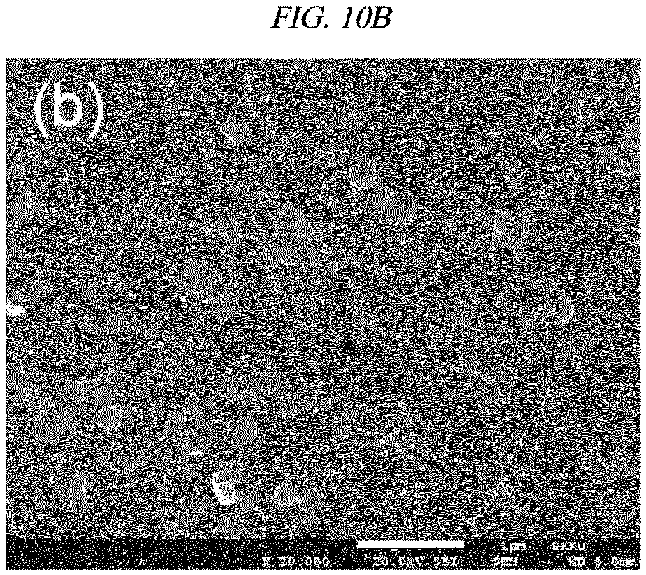

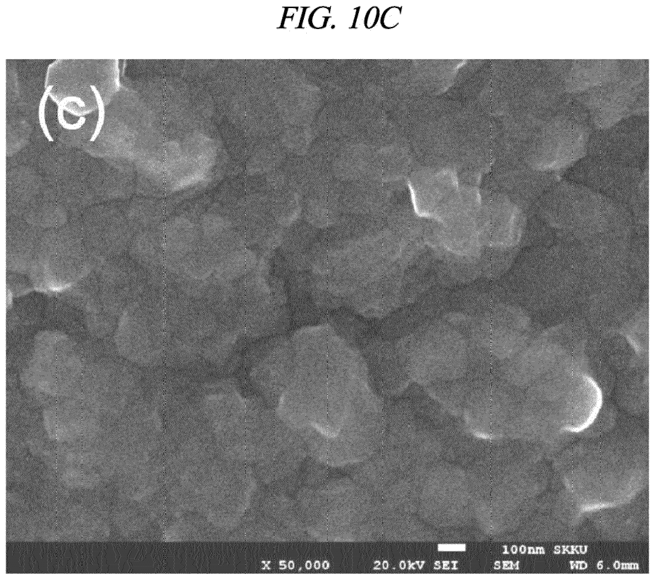

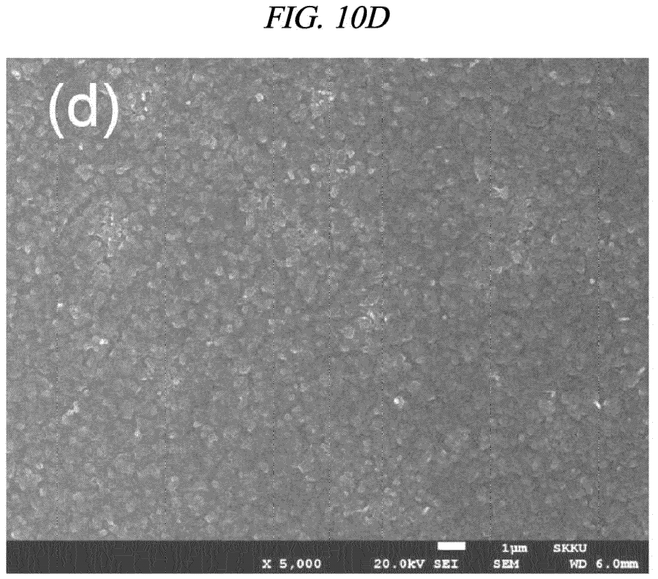

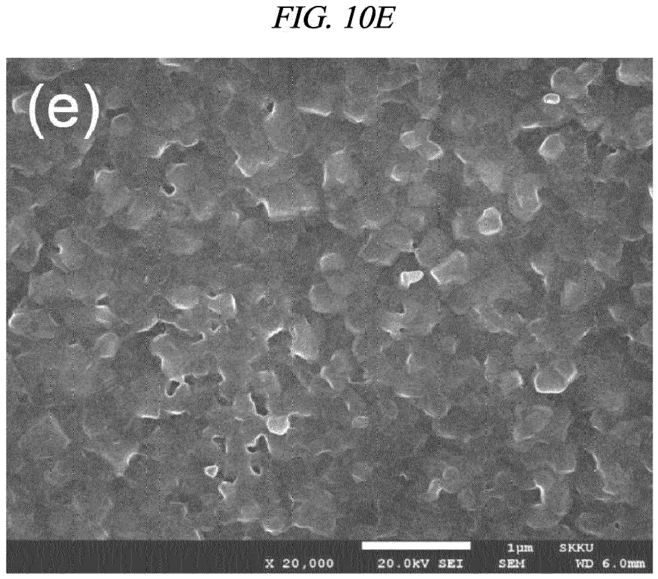

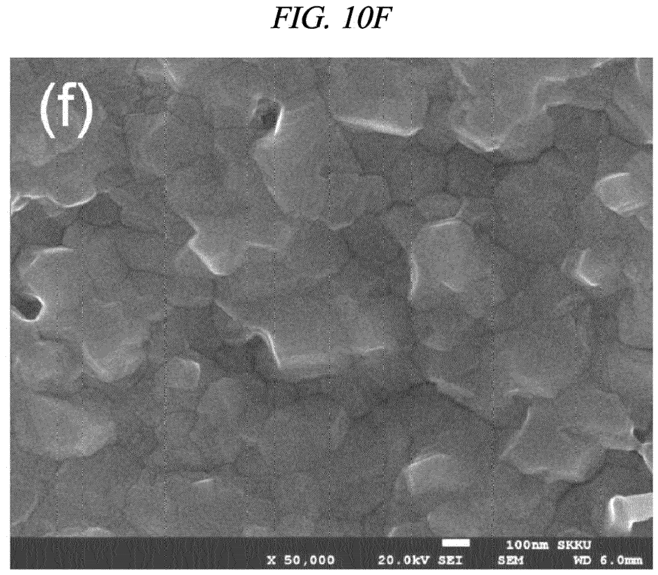

A surface coverage of $FAPbI_3$ coated on a dense $TiO_2$ layer without a porous $TiO_2$ layer (planar structure) or coated on a porous $TiO_2$ layer (mesoscopic structure) was checked in the SEM images of the upper parts **(FIG. 10A** to **FIG. 10F).** It was confirmed that these two structures were entirely filled with the $FAPbI_3$.

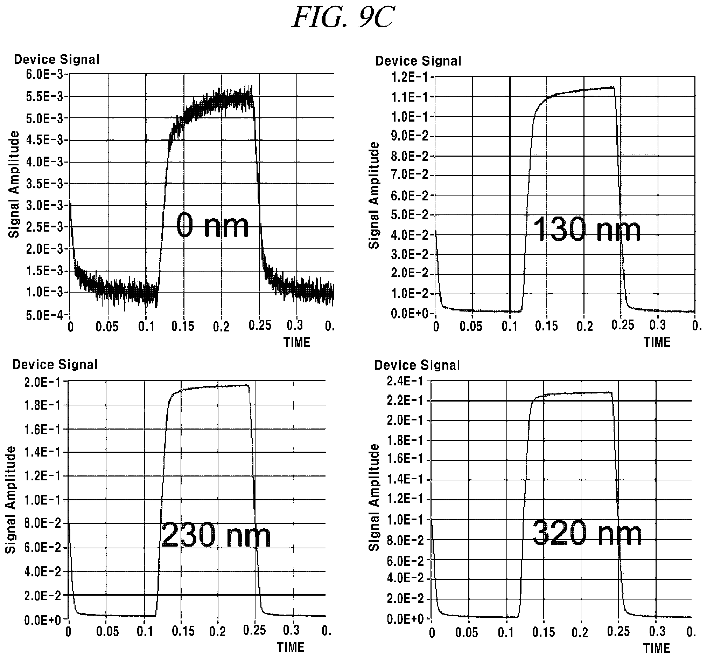

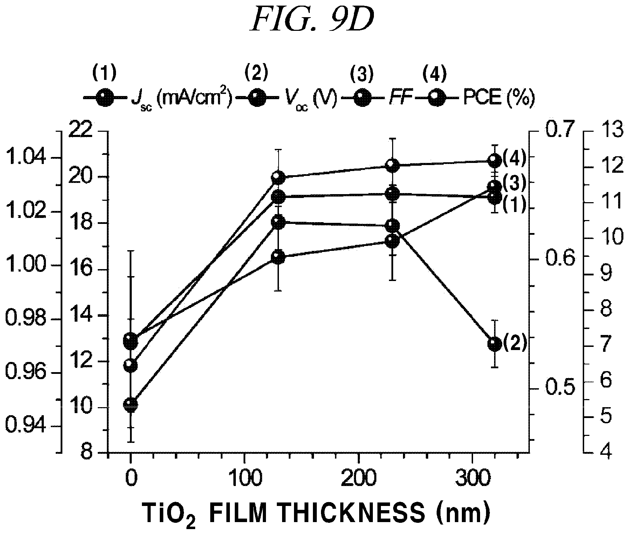

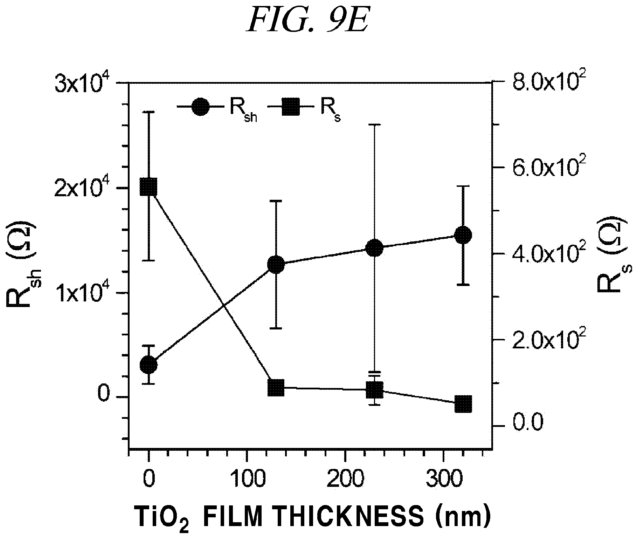

The presence and absence of a porous $TiO_2$ film and a thickness of the $TiO_2$ film considerably affect a charge collection rate **(FIG. 9C),** photovoltaic performance **(FIG. 9D),** shunt, and series resistances **(FIG. 9E).**

As shown in **FIG. 9C,** a time-limited photocurrent signal was detected under 550 nm-monochromatic beam.

A low amplitude of the device signal, associated with charge collection, and slow kinetics were observed in the $FAPbI_3$ Perovskite solar cell without a porous $TiO_2$ film.

Meanwhile, the device signal amplitude was increased with an increase in thickness of a $TiO_2$ film, along with a fast collection rate.

The presence of a porous $TiO_2$ film is important in facilitating photocurrent collection.

$J_{SC}$ was significantly improved from about 13 mA/cm$^2$ to about 19 mA/cm$^2$ by introduction of the porous $TiO_2$ film.

$V_{OC}$ was also improved from 948 mV to 1,015 mV, but slightly decreased to 971 mV in the 320 nm-$TiO_2$ film.

The slight decrease of $V_{oc}$ in the 320 nm-$TiO_2$ film may be probably associated with recombination caused by the increased $FAPbI_3$ layer.

As compared with the device without a porous $TiO_2$ film, FF is increased when a porous $TiO_2$ film is included

and as its thickness is increased.

A series resistance is decreased by more than one order of magnitude and a shunt resistance is increased by 4.6 times **(FIG.** 9E), which results from the improved fill factor.

A high series resistance and a low shunt resistance in a FAPbI$_3$ layer without a porous TiO$_2$ film indicates the presence of a resistance-related component.

An abrupt decrease in series resistance and increase in shunt resistance by including a porous TiO$_2$ film implies that underlying resistance components are removed by the presence of the TiO$_2$ film probably as a result of charge separation at the TiO$_2$/FAPbI$_3$ interface.

The origin of shunt resistance may be deduced from the area uncovered with FAPbI$_3$ associated with leakage paths, which is however ruled out since the full coverage of FAPbI$_3$ is found both in planar and mesoporous structures, as shown in FIG. 10A to **FIG.** 10F.

An abrupt decrease of shunt resistance upon removal of a porous TiO$_2$ layer obviously indicates that the porous TiO$_2$ layer is important in protecting shun current.

The function of the porous TiO$_2$ layer is clear as demonstrated by a gradual increase of shunt resistance along with an increase of a TiO$_2$ layer.

Detection of IPCE is also affected by the presence and thickness of a TiO$_2$ film.

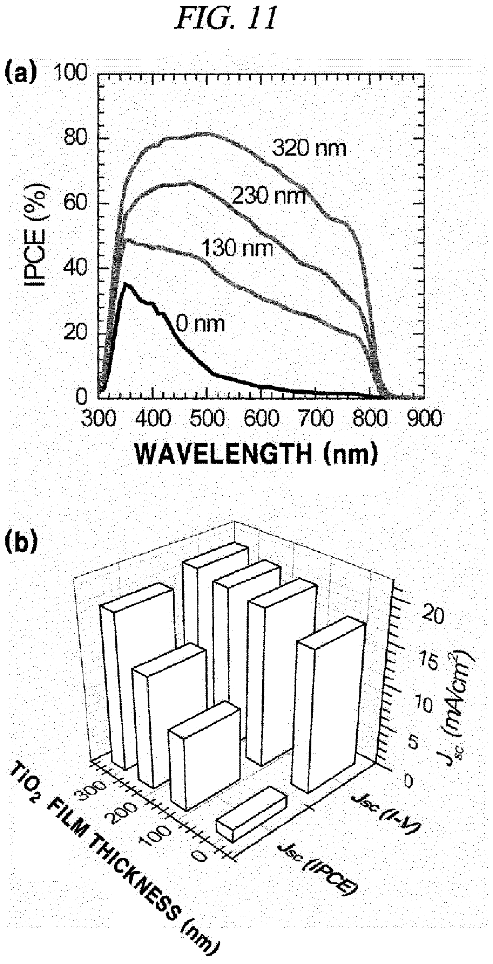

While a large discrepancy was observed with a decrease in thickness of a TiO$_2$ film **(FIG. 11A** and **FIG.** 11B), integrated J$_{sc}$ (18.9 mA/cm$^2$) calculated from ICPE data was almost identical to J$_{SC}$ (20.2 mA/cm$^2$) obtained from a sun simulation with respect to the 320 nm-TiO$_2$ film.

The improvement in IPCE signal by including and increasing a porous TiO$_2$ layer indirectly proves injection of electrons into a TiO$_2$ layer, which can be explained partially as a basis for resistance change.

Therefore, the presence of a porous TiO$_2$ layer is advantageous as compared with a planar structure in terms of resistance control and charge collection.

Further, the excellent photovoltaic performance of a porous TiO$_2$ solar cell is associated with an unbalanced electron-hole diffusion length of FAPbI$_3$.

In a Perovskite methylammonium lead iodide, it was considered that as for a FAPbI$_3$ layer, an uneven surface was more suitable for electron and hole diffusion and charge separation than an even surface on the basis of a balanced electron and hole transport characteristic.

To this end, in the present disclosure, a mixed porous TiO$_2$ nanostructure including small and large pores by means of variation of content of polymer vehicle ethyl cellulose (EC) in TiO$_2$ paste was designed.

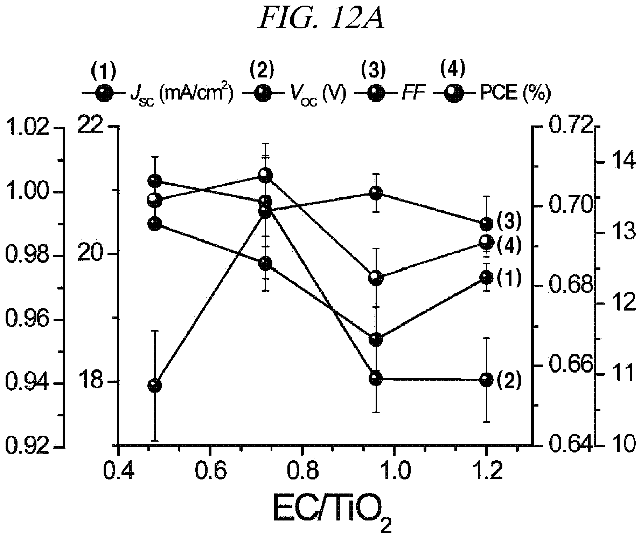

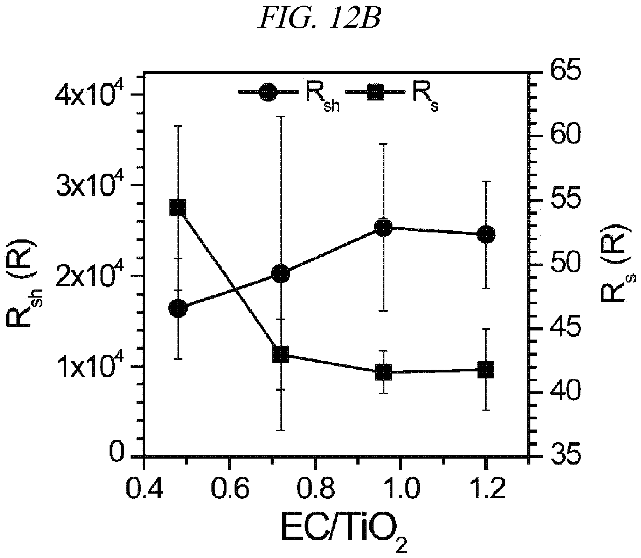

A significant improvement in FF was achieved by increasing EC content from EC/TiO$_2$ = 0.48 to 0.72 **(FIG. 12A),** which is caused by a decrease in series resistance and an increase in shunt resistance **(FIG. 12B).**

The microporous structure formed by high EC content is expected to induce large FAPbI$_3$ crystals, which is likely to reduce the number of grain boundaries relating to resistance components.

As a consequence of improvement in FF, PCE was improved in spite of slightly decreased J$_{SC}$ and V$_{OC}$.

Too much EC content is not recommended because of the loss of V$_{OC}$.

An increase in amount of EC results in large pores (100 nm or more) together with small pores (about 50 nm).

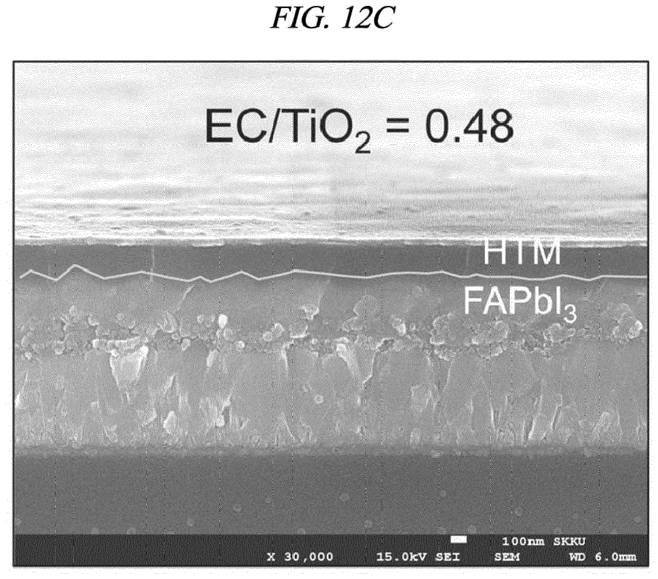

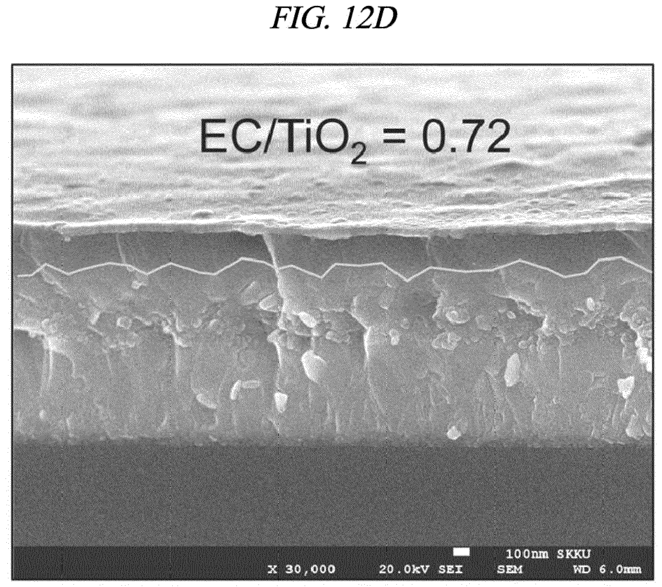

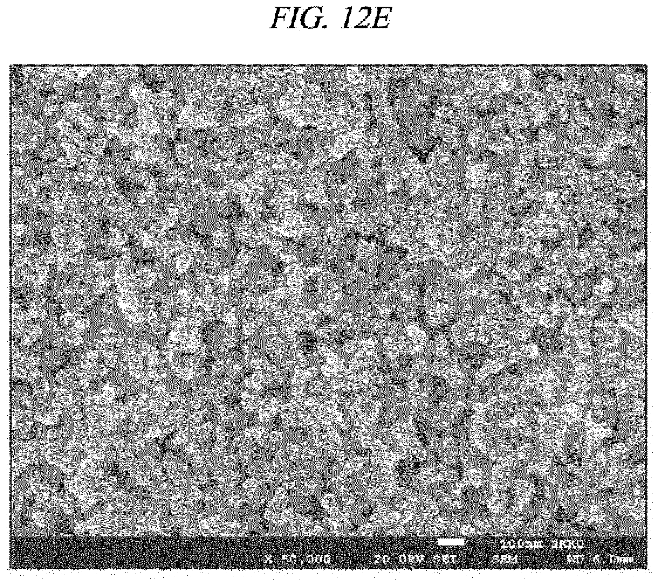

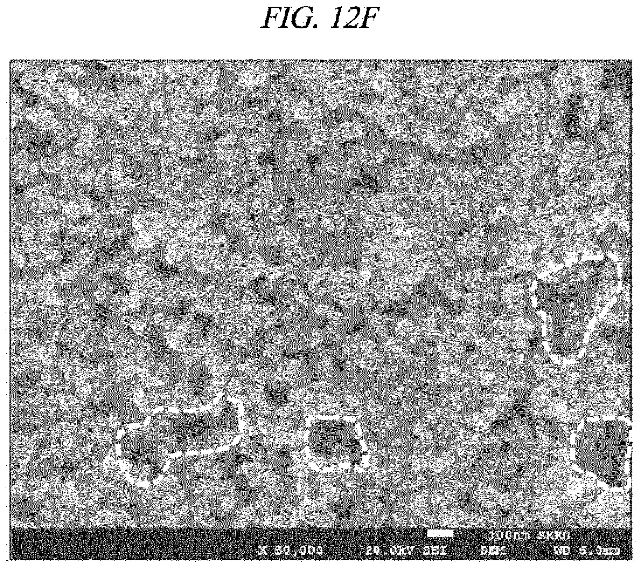

These mixed pores led to a TiO$_2$ film including large pores of about 300 nm along with addition of EC as shown in **FIG. 12D** and **FIG. 12F** and thus led to an uneven surface of FAPbI$_3$ as compared with a TiO$_2$ film including pores of from 40 nm to 100 nm **(FIG. 12C** and **FIG. 12E).**

From the systematic evaluation, it is clear that a meso-micro porous TiO$_2$ film is needed to decrease a series resistance and increase a shunt resistance in a FAPbI$_3$ Perovskite solar cell.

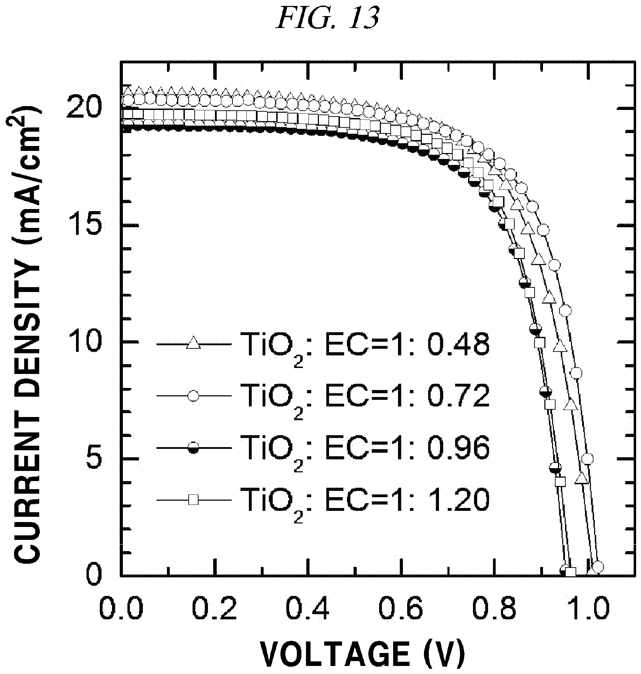

**FIG. 13** shows a current-voltage characteristic depending on a composition ratio of a polymer in TiO$_2$ nanoparticle paste used for forming a porous TiO$_2$ nanoparticle layer, and it could be seen that when a ratio of the TiO$_2$ nanoparticles : polymer (ethyl cellulose) was 1:0.72, the highest efficiency was obtained, and also it could be seen that a fill factor (FF) was improved depending on a composition ratio of the polymer.

The following Table 4 shows photocurrent density (J$_{SC}$), photovoltage (V$_{OC}$), fill factor (FF), and photo-to-electron conversion efficiency depending on a ratio of the polymer in the TiO$_2$ nanoparticle paste in preparing a HC(NH$_2$)$_2$PbI$_3$ Perovskite solar cell.

[Table 4]

| Content (TiO$_2$ : EC) | J$_{SC}$(mA/cm$^2$) | V$_{OC}$ (V) | FF | Efficiency (%) |
|---|---|---|---|---|
| 1:0.48 | 20.6 | 1.011 | 0.67 | 13.9 |
| 1:0.72 | 20.33 | 1.022 | 0.69 | 14.32 |
| 1:0.96 | 19.3 | 0.953 | 0.7 | 12.78 |

(continued)

| Content ($TiO_2$:EC) | $J_{SC}$ (mA/cm$^2$) | $V_{OC}$ (V) | FF | Efficiency (%) |
|---|---|---|---|---|
| 1:1.20 | 19.75 | 0.964 | 0.69 | 13.19 |

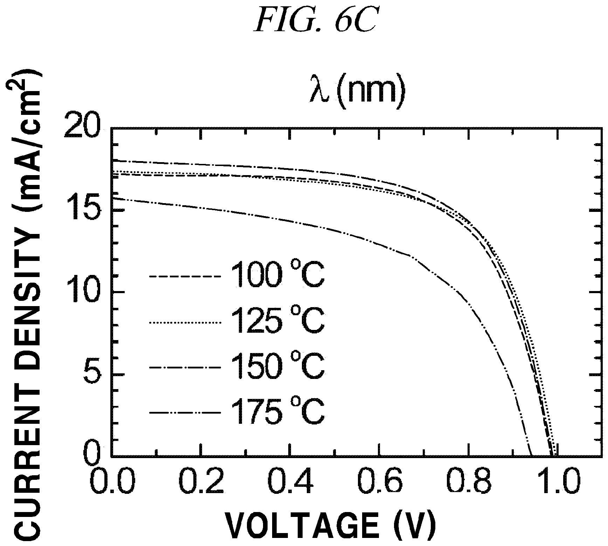

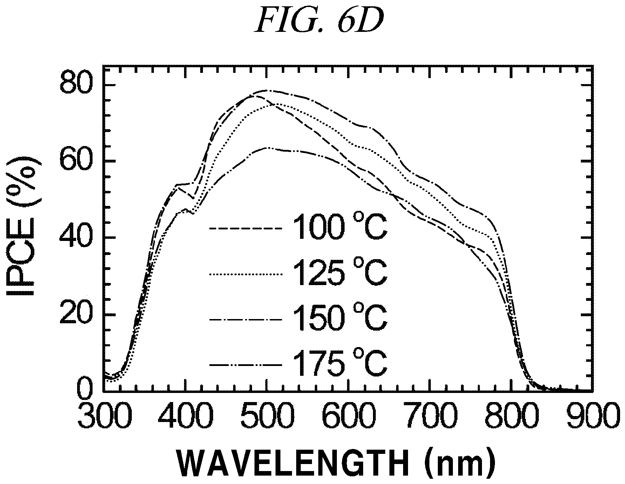

**FIG. 12C** and **FIG. 12D** are electron microscopic cross-sectional images depending on a composition ratio of a polymer in $TiO_2$ nanoparticle paste used for forming a porous $TiO_2$ nanoparticle layer, and it could be seen that as a composition ratio of the polymer was increased, an interface between a Perovskite layer and a hole transport layer was increased, which may contribute to the improvement in fill factor as shown in **FIG. 6C** and **FIG. 6D**.

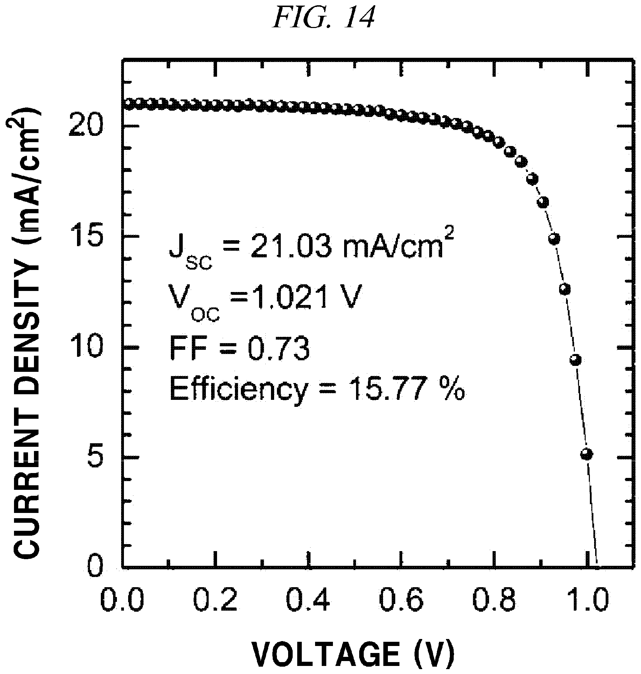

**FIG. 14** shows a photocurrent-voltage graph for a $HC(NH_2)_2PbI_3$ solar cell prepared using the most optimum conditions found through experiments, and the following Table 5 shows the results that measured 6 times photocurrent density ($J_{SC}$), photovoltage ($V_{OC}$), fill factor (FF), and photo-to-electron conversion efficiency of the $HC(NH_2)_2PbI_3$ solar cell prepared in these conditions were.

[Table 5]

| | $J_{SC}$ (mA/cm$^2$) | $V_{OC}$ (V) | FF | Efficiency (%) |
|---|---|---|---|---|
| 1 | 21.03 | 1.021 | 0.73 | 15.77 |
| 2 | 20.35 | 1.017 | 0.72 | 14.87 |
| 3 | 20.45 | 1.013 | 0.71 | 14.7 |
| 4 | 22.34 | 0.985 | 0.68 | 15.04 |
| 5 | 20.75 | 1.007 | 0.73 | 15.26 |
| 6 | 20.7 | 1.013 | 0.73 | 15.36 |
| Average | 20.94 | 1.009 | 0.72 | 15.17 |
| Standard deviation | 0.66 | 0.012 | 0.02 | 0.35 |

It could be seen from **FIG. 14** and Table 5 that the $HC(NH_2)_2PbI_3$ solar cell having an average efficiency of 15.17% was reproducibly prepared.

[Property comparison between Perovskite solar cells prepared in Example and Comparative Examples 3 and 4]

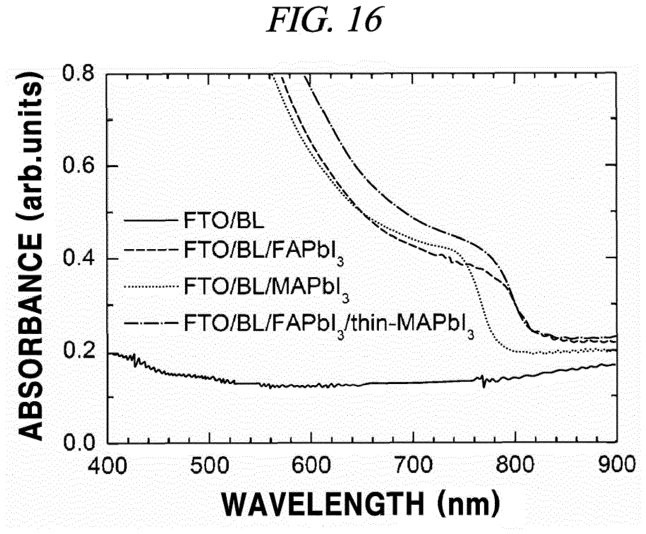

**FIG. 16** shows absorption spectra of FTO/recombination blocking layer (BL), FTO/BL/FAPbI$_3$ (Comparative Example 3), FTO/BL/MAPbI$_3$ (Comparative Example 4), and a thin film of FTO/BL/FAPbI$_3$/thin-MAPbI$_3$ (Example), respectively. The thicknesses of the FAPbI$_3$ layer and the MAPbI$_3$ layer were measured from their SEM cross sections as $247 \pm 20$ nm and $230 \pm 20$ nm, respectively.

As shown in **FIG. 16,** when comparing the absorbances, the absorbance of the MAPbI$_3$ Perovskite layer was higher than that of FAPbI$_3$ Perovskite layer in the range of from 700 nm to 800 nm. Meanwhile, it could be seen that the FAPbI$_3$ Perovskite layer had a broader absorption region. When the MAPbI$_3$ Perovskite layer was formed on the FAPbI$_3$ Perovskite layer, it was confirmed that a broad absorption region was maintained and an absorbance was increased. In this case, the MAPbI$_3$ Perovskite layer formed on the FAPbI$_3$ Perovskite layer having a thickness of 300 nm was as thin as several nm (about 10 nm or less ), and the thickness could be controlled by regulating a spin-coating speed and the amount of $CH_3NH_3I$ to be dropped during spin-coating.

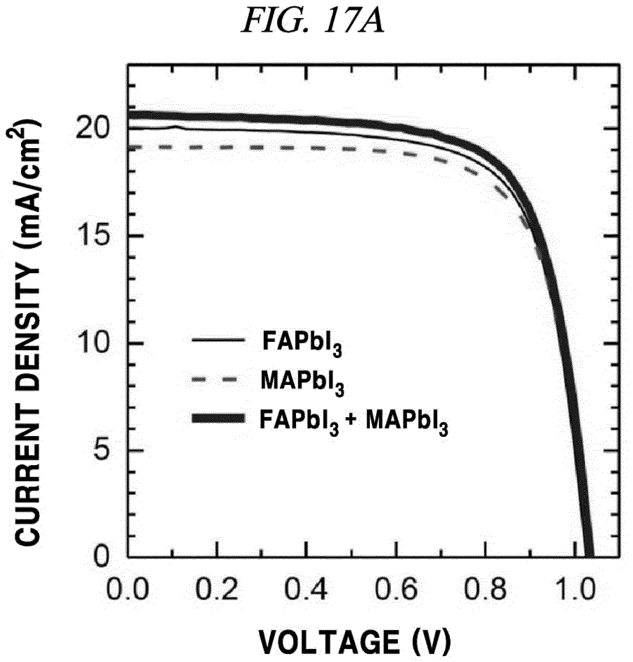

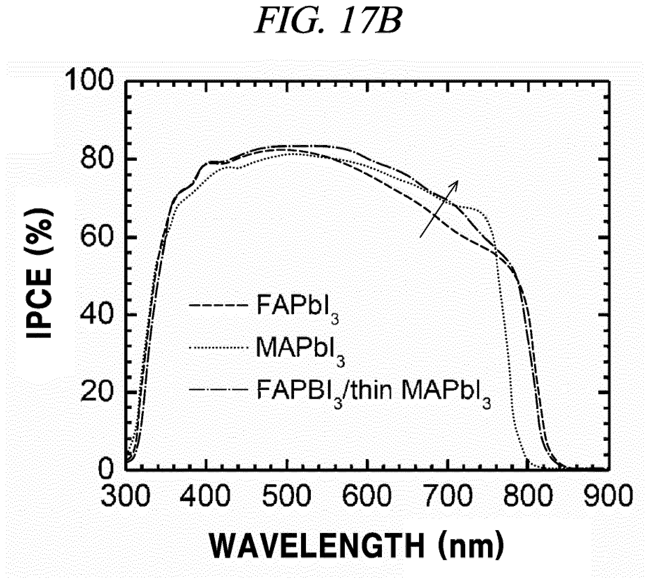

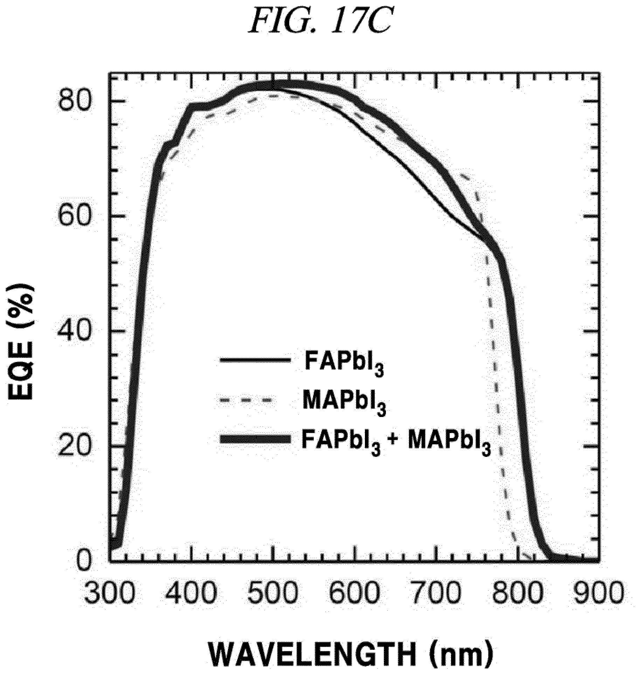

**FIG. 17A** to **FIG. 17C** show current-voltage curves **(FIG. 17A),** IPCE spectra **(FIG. 17B),** and an external quantum efficiency graph **(FIG. 17C)** of Perovskite solar cells using a FAPbI$_3$ Perovskite layer, a MAPbI$_3$ Perovskite layer, and a FAPbI$_3$/MAPbI$_3$ Perovskite double layer, respectively. When the FAPbI$_3$/MAPbI$_3$ Perovskite double layer was used, it was observed that a photocurrent and a photovoltage were improved, and it was considered that the improved photocurrent resulted in an increase in quantum efficiency in a long wavelength range, as can be seen from the external quantum efficiency graph.

Light absorption by the FAPbI$_3$ was weaker at a long wavelength than at 700 nm as compared with light absorption by the MAPbI$_3$ **(FIG.** 16), and IPCE at a long wavelength range was lower in the FAPbI$_3$ than in the MAPbI$_3$ **(FIG. 17B).**

$J_{SC}$ integrated on the basis of IPCE data was 19.57 mA/cm$^2$ in the FAPbI$_3$ and it was not much higher than $J_{SC}$ in the MAPbI$_3$ (18.90 mA/cm$^2$) due to weak absorption at a long wavelength in spite of an absorption onset extended by 40 nm.

In order to improve optical response at a long wavelength, a thin MAPbI$_3$ film was formed on a FAPbI$_3$ layer by dropping aliquots of CH$_3$NH$_3$I-dissolved 2-propanol solution while a FAPbI$_3$-coated electrode was rotated at a high spin speed of 6,000 rpm.

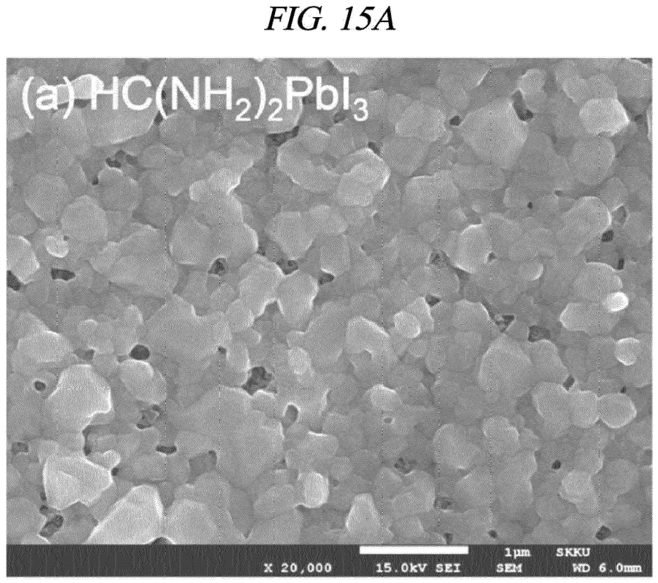

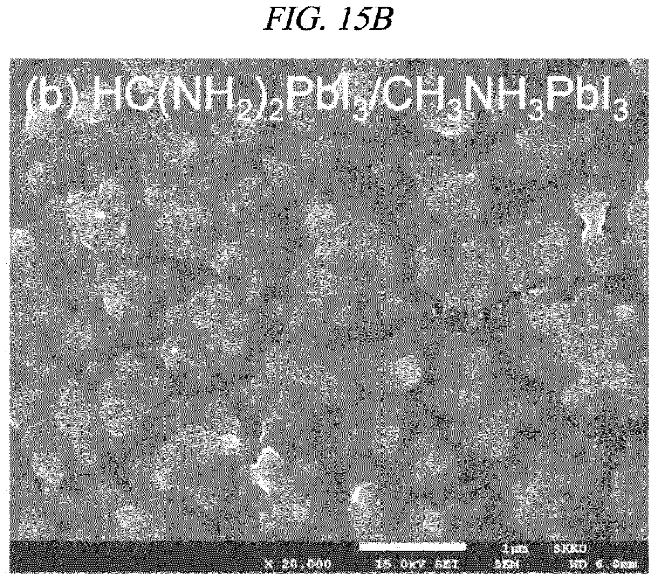

As measured by the SEM **(FIG. 15A** and **FIG. 15B),** a change in surface morphology indicates formation of a thin MAPbI$_3$ layer.

A cation exchange reaction occurred on an upper surface of the FAPbI$_3$, so that a thin MAPbI$_3$ layer was formed.

The photovoltaic performances of a FAPbI$_3$ monolayer-based Perovskite solar cell and a FAPbI$_3$/MAPbI$_3$ double layer-based Perovskite solar cell were as summarized in the following Table 6.

The following Table 6 shows the results that photovoltaic parameters of photocurrent density ($J_{SC}$), open-circuit voltage ($V_{OC}$), fill factor (FF), and power conversion efficiency (PCE) of Perovskite solar cells respectively including a FAPbI$_3$ monolayer (Comparative Example 3) and a FAPbI$_3$/MAPbI$_3$ double layer (Example) were measured 5 times. A dense TiO$_2$ blocking layer and a meso-microporous TiO$_2$ layer (EC/TiO$_2$ = 0.72) were about 40 nm and 220 nm, respectively. An active layer was 0.136 cm$^2$.

[Table 6]

| HC(NH$_2$)$_2$PbI$_3$ layer | $J_{SC}$ (mA/cm$^2$) | $V_{OC}$ (V) | FF | PCE (%) |
|---|---|---|---|---|
| 1 | 20.97 | 0.986 | 0.69 | 14.27 |
| 2 | 20.59 | 0.978 | 0.69 | 13.89 |
| 3 | 20.95 | 0.973 | 0.7 | 14.26 |
| 4 | 20.67 | 0.994 | 0.68 | 13.97 |
| 5 | 20.94 | 0.991 | 0.69 | 14.32 |
| Average | 20.82 | 0.984 | 0.69 | 14.14 |
| Standard deviation | 0.18 | 0.009 | 0.01 | 0.2 |
| HC(NH$_2$)$_2$PbI$_3$/CH$_3$NH$_3$PbI$_3$ double layer | $J_{sc}$ (mA/cm$^2$) | $V_{oc}$ (V) | FF | PCE (%) |
| 1 | 21.51 | 1.004 | 0.69 | 14.9 |
| 2 | 21.23 | 1.012 | 0.69 | 14.82 |
| 3 | 21.32 | 0.998 | 0.72 | 15.32 |
| 4 | 21.47 | 1.001 | 0.71 | 15.26 |
| 5 | 21.48 | 1 | 0.7 | 15.04 |
| Average | 21.4 | 1.003 | 0.7 | 15.07 |
| Standard deviation | 0.12 | 0.005 | 0.01 | 0.22 |

It was clear that the overlayer of the thin MAPbI$_3$ improved the averages of the photocurrent and the photovoltage by about 2.8% and about 1.9%, respectively, which resulted in improvement of PCE by about 6.6%.

The improvement was not so high, but was reproducible and reliable in consideration of a very small standard deviation.

The following Table 7 compares short circuit current density ($J_{SC}$), open circuit voltage ($V_{OC}$), fill factor(FF), and photo-to-electron conversion efficiency among a solar cell including a FAPbI$_3$/MAPbI$_3$ double layer in accordance with the present Example, a solar cell including a FAPbI$_3$ layer (Comparative Example 3) and a solar cell including a MAPbI$_3$ layer (Comparative Example 4).

[Table 7]

| | $J_{SC}$ (mA/cm$^2$) | $V_{OC}$ (V) | FF | Efficiency (%) |
|---|---|---|---|---|
| HC(NH$_2$)$_2$PbI$_3$ layer | 20.01 | 1.026 | 0.72 | 14.78 |
| CH$_3$NH$_3$PbI$_3$ layer | 19.15 | 1.034 | 0.72 | 14.26 |
| HC(NH$_2$)$_2$PbI$_3$/CH$_3$NH$_3$PbI$_3$ double layer | 20.64 | 1.036 | 0.71 | 15.22 |

After a thin MAPbI$_3$ overlayer was formed on FAPbI$_3$, integrated J$_{sc}$ was improved from 19.57 mA/cm$^2$ to 20.22 mA/cm$^2$ due to an improved IPCE at a long wavelength as shown in **FIG. 17B.**

It was interesting to observe that an absorption onset was hardly shifted due to the thin MAPbI$_3$ overlayer.

In addition to the increase in J$_{sc}$, the thin MAPbI$_3$ overlayer caused an increase in V$_{oc}$, which may be associated with the removal of defects from the FAPbI$_3$ layer by the thin MAPbI$_3$ overlayer (compare **FIG. 15A** and **FIG. 15B).**

Further, a valence band maximum (VBM) of the FAPbI$_3$ was -5.4 eV, which was similar to that (-5.43 eV) of the MaPbI$_3$.

A lower band gap of the FAPbI$_3$ may lead to a slightly lower conduction band minimum (CBM) of -4.0 eV than the MAPbI$_3$ (-3.93 eV).

Perhaps, the thin MaPbI$_3$ overlayer may increase the CBM at an interface with the HTM and thus may result in an increase in V$_{oc}$.

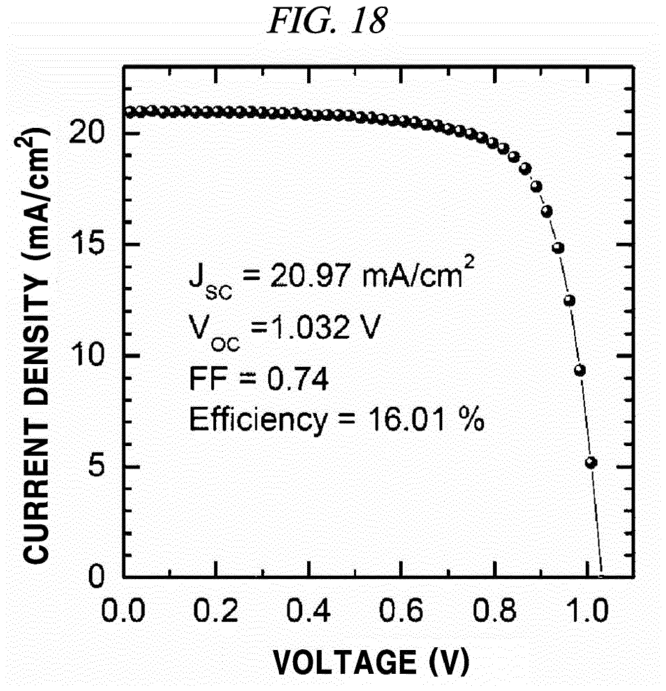

FIG. 18 shows a current-voltage curve of a high-efficiency Perovskite solar cell according to the invention using a FAPbI$_3$/MAPbI$_3$ double layer structure in accordance with an example of the present disclosure.

In order to obtain high J$_{SC}$ and FF based on the nano-engineering technology of the present disclosure, a most superior PCE of 16.01% was achieved (FIG. 18) and an average PCE of 15.56% with a standard deviation of 0.33 was obtained from the FAPbI$_3$ Perovskite solar cell (Table 8), and the average J$_{sc}$, V$_{oc}$, and FF were 20.91 mA/cm$^2$, 1.036 V, and 0.72, respectively.

The following Table 8 shows the results that photovoltaic parameters of photocurrent density (J$_{SC}$), open-circuit voltage (V$_{OC}$), fill factor (FF), and power conversion efficiency (PCE) of Perovskite solar cells respectively including a FAPbI$_3$/MAPbI$_3$ double layer (Example) were measured 5 times. A dense TiO$_2$ blocking layer and a meso-microporous TiO$_2$ layer (EC/TiO$_2$ = 0.72) were about 40 nm and 160 nm, respectively. An active layer was 0.136 cm$^2$.

[Table 8]

| HC(NH$_2$)$_2$PbI$_3$/CH$_3$NH$_3$PbI$_3$ double layer | $J_{SC}$ (mA/cm$^2$) | $V_{OC}$ (V) | $FF$ | PCE (%) |
|---|---|---|---|---|
| 1 | 20.97 | 1.032 | 0.74 | 16.01 |
| 2 | 20.86 | 1.037 | 0.72 | 15.58 |
| 3 | 20.8 | 1.031 | 0.72 | 15.44 |
| 4 | 21.25 | 1.043 | 0.71 | 15.74 |
| 5 | 20.68 | 1.037 | 0.7 | 15.01 |
| Average | 20.91 | 1.036 | 0.72 | 15.56 |
| Standard deviation | 0.19 | 0.004 | 0.01 | 0.33 |

A scan direction test was conducted for checking J-V hysteresis behavior.

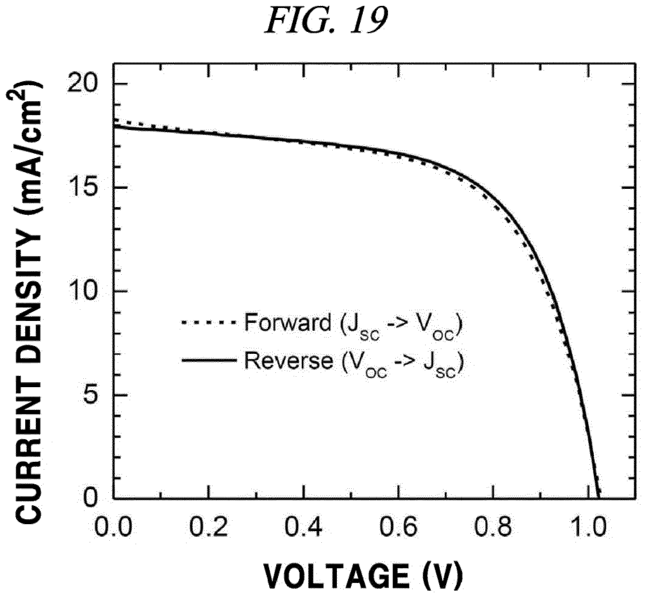

In a current-voltage curve, a slight difference was rarely found in forward (J$_{SC}$ to V$_{OC}$) and reverse (V$_{OC}$ to J$_{SC}$) scans during a current-voltage measurement (FIG. 19).

As for MAPbI$_3$, a considerable hysteresis was observed due to reorientation of permanent dipoles of CH$_3$NH$_3$$^+$.

Therefore, it can be expected that HC(NH$_2$)$_2$$^+$ in a FAPbI$_3$ Perovskite structure is stable in an electric field.

Finally, a photostability was checked by repeated measuring a current-voltage under one sun illumination.

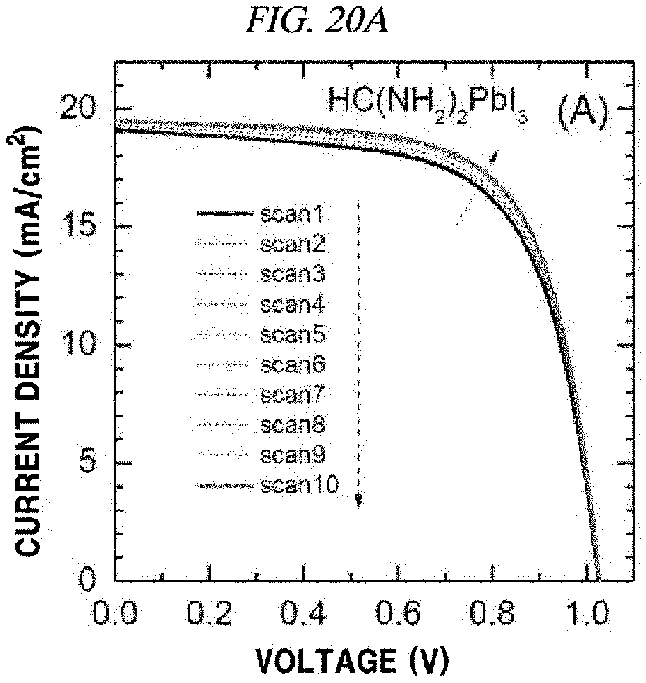

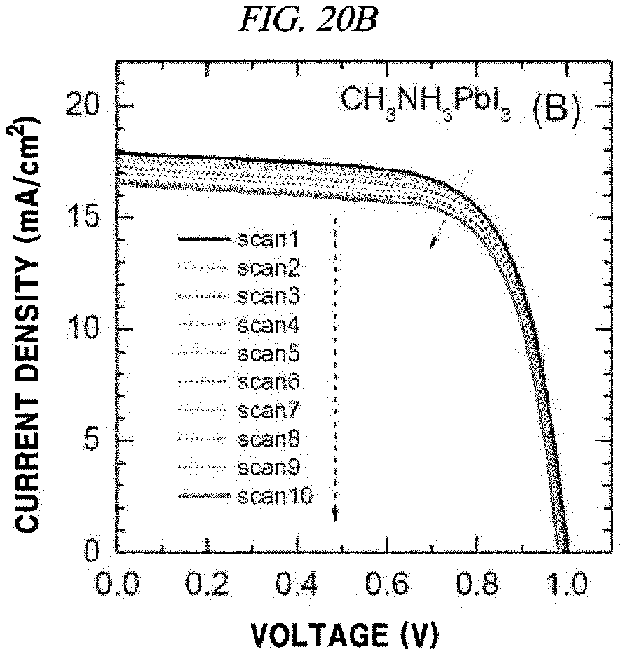

A MAPbI$_3$-based Perovskite solar cell deteriorated, whereas a FAPbI$_3$-based Perovskite solar cell was considerably stable **(FIG. 20A** and **FIG. 20B),** which implies that FAPbI$_3$ is superior in photostability to MAPbI$_3$.

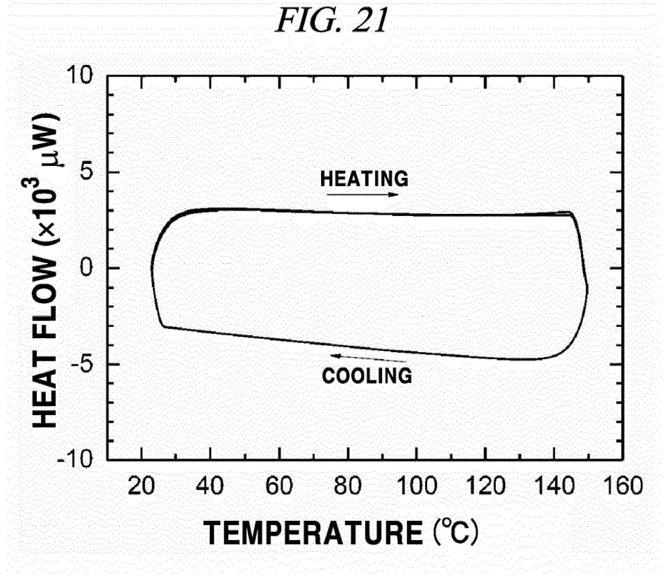

Although a phase transition has not been mentioned in conventional studies, the present disclosure confirmed that FAPbI$_3$ did not undergo a phase transition between 23 °C and 150 °C from a DSC **(FIG. 21).**

To summarize, a methylammonium lead iodide HC(NH$_2$)$_2$PbI$_3$-based high-efficiency, J-V hysteresis-free and photo-stable Perovskite solar cell was successfully prepared. HC(NH$_2$)$_2$PbI$_3$ was prepared by immersing a PbI$_2$-coated electrode in a HC(NH$_2$)$_2$I solution. It was found that the annealing temperature and time for the deposited HC(NH$_2$)$_2$PbI$_3$ is very important for photovoltaic performance. A black HC(NH$_2$)$_2$PbI$_3$ polymorph formed at 150°C for 15 minutes showed the highest photocurrent. It was also found that a porous TiO$_2$ layer is important for improvement in other parameters such as charge collection, fill factor, and voltage. A high fill factor was realized by engineering a porous structure of the TiO$_2$ layer via EC/TiO$_2$ ratio control. Weak absorption at a long wavelength was overcome by introduction of a very thin CH$_3$NH$_3$PbI$_3$ layer on a HC(NH$_2$)$_2$PbI$_3$ layer, both layers forming an exemplary photoactive layer of the Perovskite solar cell according to claim 1. AS a result, an average PCE of 15.56% was achieved at the HC(NH$_2$)$_2$PbI$_3$ layer having a thickness of about 300 nm including the thin CH$_3$NH$_3$PbI$_3$ layer formed on a meso-micro porous TiO$_2$ film having a thickness of 150 ± 50 nm. The maximum PCE of 16.01% was obtained by the method developed in the present disclosure. Considering that there will be no photostability and crystal phase transition at an operation temperature of a solar cell,

$HC(NH_2)_2PbI_3$ is promising for a high-efficiency Perovskite solar cell.

The scope of the present disclosure is defined by the following claims rather than by the detailed description of the embodiment.

**Claims**

1. A Perovskite solar cell, comprising:

   a first electrode including a transparent conductive substrate;
   a recombination-preventing layer formed on the first electrode;
   a photoactive layer formed on the recombination-preventing layer;
   a hole transport layer formed on the photoactive layer; and
   a second electrode formed on the hole transport layer,
   wherein the photoactive layer consists of a Perovskite double layer consisting of a layer of a first Perovskite represented by the following Chemical Formula 1 and a layer of a second Perovskite represented by the following Chemical Formula 2 formed on the layer of the first Perovskite:

   [Chemical Formula 1]        $RMX_3$

   wherein, in Chemical Formula 1,

   R includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof,
   M includes a +2 metal cation selected from the group consisting of $Pb^{2+}$, $Sn^{2+}$, $Ge^{2+}$, and combinations thereof, and
   X is a halogen anion;

   [Chemical Formula 2]        $R'M'X'_3$

   wherein, in the Chemical Formula 2,

   R' includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof,
   M' includes a +2 metal cation selected from the group consisting of $Pb^{2+}$, $Sn^{2+}$, $Ge^{2+}$, and combinations thereof, and
   X' is a halogen anion;
   **characterized in that** the cation R included in the Chemical Formula 1 and the cation R' included in the Chemical Formula 2 are different from each other and the metal cation M' is the same as M.

2. The Perovskite solar cell of Claim 1,
   wherein the cation R included in the first Perovskite includes formamidinium ion, and the cation R' included in the second perovskite includes methylammonium cation.

3. The Perovskite solar cell of Claim 1,
   wherein a thickness of the layer of the second Perovskite is 300 nm or less.

4. The Perovskite solar cell of Claim 1,
   wherein the photoactive layer further includes a semiconductor layer.

5. The Perovskite solar cell of Claim 4,
   wherein the semiconductor layer has a porous structure including pores of from 20 nm to 500 nm.

6. The Perovskite solar cell of Claim 1,

wherein the hole transport layer includes a unimolecular or polymeric hole transport material.

7. A method of preparing a Perovskite solar cell, comprising:

forming a recombination-preventing layer on a first electrode including a transparent conductive substrate;
forming a photoactive layer on the recombination-preventing layer;
forming a hole transport layer on the photoactive layer; and
forming a second electrode on the hole transport layer,
wherein the forming of the photoactive layer includes coating a solution containing a first Perovskite represented by the following Chemical Formula 1 on the recombination-preventing layer to form a layer of the first Perovskite and coating a solution containing a precursor R'X' for preparing a second Perovskite on the layer of the first Perovskite to form a layer of the second Perovskite represented by the following Chemical Formula 2 so as to form a Perovskite double layer consisting of the layer of the first Perovskite and the layer of the second Perovskite:

[Chemical Formula 1]       $RMX_3$

wherein, in Chemical Formula 1,

R includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof,
M includes a +2 metal cation selected from the group consisting of $Pb^{2+}$, $Sn^{2+}$, $Ge^{2+}$, and combinations thereof, and
X is a halogen anion;

[Chemical Formula 2]       $R'M'X'_3$

wherein, in Chemical Formula 2,

R' includes a +1 cation selected from the group consisting of $C_nH_{2n+1}NH_3^+$ wherein n is an integer of from 1 to 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, and combinations thereof,
M' includes a +2 metal cation selected from the group consisting of $Pb^{2+}$, $Sn^{2+}$, $Ge^{2+}$, and combinations thereof, and
X' is a halogen anion;
**characterized in that** the forming of the Perovskite double layer, after forming the layer of the first Perovskite by coating the solution containing the first Perovskite on the recombination-preventing layer, includes coating the solution containing the precursor R'X' for preparing the second Perovskite on the layer of the first Perovskite to replace the cation R included in the first Perovskite with the cation R' included in the precursor for preparing the second Perovskite so as to form the layer of the second Perovskite on the layer of the first Perovskite, wherein the cation R included in the Chemical Formula 1 and the cation R' included in the Chemical Formula 2 are different from each other and the metal cation M' is the same as M.

8. The method of preparing the Perovskite solar cell of Claim 7,
wherein the cation R included in the first Perovskite includes formamidinium ion, and
wherein the cation R' included in the second perovskite includes methylammonium cation.

9. The method of preparing the Perovskite solar cell of Claim 7,
wherein a thickness of the layer of the second Perovskite is 300 nm or less.

10. The method of preparing the Perovskite solar cell of Claim 7,
wherein the photoactive layer further includes a semiconductor layer.

11. The method of preparing the Perovskite solar cell of Claim 10,
wherein the semiconductor layer has a porous structure including pores of from 20 nm to 500 nm.

12. The method of preparing the Perovskite solar cell of Claim 7,
wherein, the forming the photoactive layer, after forming the Perovskite double layer including the layer of the first Perovskite and the layer of the second Perovskite, further includes annealing the photoactive layer including the Perovskite double layer at from 100°C to 170°C.

13. The method of preparing the Perovskite solar cell of Claim 10,
further comprising annealing the photoactive layer further including the semiconductor layer at from 100°C to 170°C.

**Patentansprüche**

1. Perowskit-Solarzelle, welche umfasst:

eine erste Elektrode, die ein transparentes, leitfähiges Substrat enthält;
eine auf der ersten Elektrode gebildete, Rekombination verhindernde Schicht;
eine auf der Rekombination verhindernden Schicht gebildete, photoaktive Schicht;
eine auf der photoaktiven Schicht gebildete Lochtransportschicht; und
eine auf der Lochtransportschicht gebildete zweite Elektrode,
wobei die photoaktive Schicht aus einer Perowskit-Doppelschicht besteht, die aus einer Schicht eines durch die folgende Chemische Formel 1 dargestellten ersten Perowskits und einer auf der Schicht des ersten Perwoskits gebildeten Schicht eines durch die folgende Chemische Formel 2 dargestellten zweiten Perowskits besteht:

[Chemische Formel 1]     $RMX_3$

wobei in der Chemischen Formel 1

R ein +1-Kation enthält, welches aus der Gruppe ausgewählt ist, die aus $C_nH_{2n+1}NH_3^+$, wobei n eine ganze Zahl von 1 bis 9 ist, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$ und Kombinationen derselben besteht,
M ein +2-Metallkation enthält, welches aus der Gruppe ausgewählt ist, die aus $Pb^{2+}$, $Sn^{2+}$, $Ge^{2+}$ und Kombinationen derselben besteht, und
X ein Halogen-Anion ist;

[Chemische Formel 2]     $R'M'X'_3$

wobei in der Chemischen Formel 2

R' ein +1-Kation enthält, welches aus der Gruppe ausgewählt ist, die aus $C_nH_{2n+1}NH_3^+$, wobei n eine ganze Zahl von 1 bis 9 ist, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$ und Kombinationen derselben besteht,
M' ein +2-Metallkation enthält, welches aus der Gruppe ausgewählt ist, die aus $Pb^{2+}$, $Sn^{2+}$, $Ge^{2+}$ und Kombinationen derselben besteht, und
X' ein Halogen-Anion ist;
**dadurch gekennzeichnet, dass** das in der Chemischen Formel 1 enthaltene Kation R und das in der Chemischen Formel 2 enthaltene Kation R' voneinander verschieden sind und das Metallkation M' das gleiche ist wie M.

2. Perowskit-Solarzelle nach Anspruch 1,
wobei das in dem ersten Perowskit enthaltene Kation R ein Formamidinium-Ion enthält, und das in dem zweiten Perowskit enthaltene Kation R' ein Methylammonium-Kation enthält.

3. Perowskit-Solarzelle nach Anspruch 1,
wobei eine Dicke der Schicht des zweiten Perowskits 300 nm oder weniger beträgt.

4. Perowskit-Solarzelle nach Anspruch 1,
wobei die photoaktive Schicht zudem eine Halbleiterschicht enthält.

5. Perowskit-Solarzelle nach Anspruch 4,
wobei die Halbleiterschicht eine poröse Struktur aufweist, die Poren von 20 nm bis 500 nm enthält.

6. Perowskit-Solarzelle nach Anspruch 1,
wobei die Lochtransportschicht ein unimolekulares oder polymeres Lochtransportmaterial enthält.

7. Verfahren zur Herstellung einer Perowskit-Solarzelle, welches umfasst:

Bilden einer Rekombination verhindernden Schicht auf einer ersten Elektrode, die ein transparentes, leitfähiges Substrat enthält;
Bilden einer photoaktiven Schicht auf der Rekombination verhindernden Schicht;
Bilden einer Lochtransportschicht auf der photoaktiven Schicht; und
Bilden einer zweiten Elektrode auf der Lochtransportschicht,
wobei das Bilden der photoaktiven Schicht das Beschichten der Rekombination verhindernden Schicht mit einer einen durch die folgende Chemische Formel 1 dargestellten ersten Perowskit enthaltenden Lösung, um eine Schicht des ersten Perowskits zu bilden, und das Beschichten der Schicht des ersten Perowskits mit einer einen Vorläufer R'X' für die Herstellung eines zweiten Perowskits enthaltenden Lösung, um eine Schicht des durch die folgende Chemische Formel 2 dargestellten zweiten Perowskits zu bilden, umfasst, so dass eine Perowskit-Doppelschicht gebildet wird, die aus der Schicht des ersten Perowskits und der Schicht des zweiten Perowskits besteht:

[Chemische Formel 1]  $RMX_3$

wobei in der Chemischen Formel 1

R ein +1-Kation enthält, welches aus der Gruppe ausgewählt ist, die aus $C_nH_{2n+1}NH_3^+$, wobei n eine ganze Zahl von 1 bis 9 ist, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$ und Kombinationen derselben besteht,
M ein +2-Metallkation enthält, welches aus der Gruppe ausgewählt ist, die aus $Pb^{2+}$, $Sn^{2+}$, $Ge^{2+}$ und Kombinationen derselben besteht, und
X ein Halogen-Anion ist;

[Chemische Formel 2]  $R'M'X'_3$

wobei in der Chemischen Formel 2

R' ein +1-Kation enthält, welches aus der Gruppe ausgewählt ist, die aus $C_nH_{2n+1}NH_3^+$, wobei n eine ganze Zahl von 1 bis 9 ist, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$ und Kombinationen derselben besteht,
M' ein +2-Metallkation enthält, welches aus der Gruppe ausgewählt ist, die aus $Pb^{2+}$, $Sn^{2+}$, $Ge^{2+}$ und Kombinationen derselben besteht, und
X' ein Halogen-Anion ist;
**dadurch gekennzeichnet, dass** das Bilden der Perowskit-Doppelschicht, nach dem Bilden der Schicht des ersten Perowskits durch Beschichten der Rekombination verhindernden Schicht mit der den ersten Perowskit enthaltenden Lösung, das Beschichten der Schicht des ersten Perowskits mit der den Vorläufer R'X' für die Herstellung des zweiten Perowskits enthaltenden Lösung umfasst, um das im ersten Perowskit enthaltene Kation R mit dem im Vorläufer für die Herstellung des zweiten Perowskits enthaltenen Kation R' zu ersetzen, so dass die Schicht des zweiten Perowskits auf der Schicht des ersten Perowskits gebildet wird, wobei das in der Chemischen Formel 1 enthaltene Kation R und das in der Chemischen Formel 2 enthaltene Kation R' voneinander verschieden sind und das Metallkation M' das gleiche ist wie M.

8. Verfahren zur Herstellung einer Perowskit-Solarzelle nach Anspruch 7,
wobei das in dem ersten Perowskit enthaltene Kation R ein Formamidinium-Ion enthält, und das in dem zweiten Perowskit enthaltene Kation R' ein Methylammonium-Kation enthält.

9. Verfahren zur Herstellung einer Perowskit-Solarzelle nach Anspruch 7,
   wobei eine Dicke der Schicht des zweiten Perowskits 300 nm oder weniger beträgt.

10. Verfahren zur Herstellung einer Perowskit-Solarzelle nach Anspruch 7,
    wobei die photoaktive Schicht zudem eine Halbleiterschicht enthält.

11. Verfahren zur Herstellung einer Perowskit-Solarzelle nach Anspruch 10,
    wobei die Halbleiterschicht eine poröse Struktur aufweist, die Poren von 20 nm bis 500 nm enthält.

12. Verfahren zur Herstellung einer Perowskit-Solarzelle nach Anspruch 7,
    wobei das Bilden der photoaktiven Schicht, nach dem Bilden der Perowskit-Doppelschicht, welche die Schicht des ersten Perowskits und die Schicht des zweiten Perowskits enthält, zudem das Tempern der photoaktiven Schicht, welche die Perowskit-Doppelschicht enthält, bei 100°C bis 170°C umfasst.

13. Verfahren zur Herstellung einer Perowskit-Solarzelle nach Anspruch 10,
    welches zudem das Tempern der photoaktiven Schicht, die zudem die Halbleiterschicht enthält, bei 100°C bis 170°C umfasst.

## Revendications

1. Cellule solaire en perovskite, comprenant :

   une première électrode comprenant un substrat conducteur transparent ;
   une couche empêchant une recombinaison formée sur la première électrode ;
   une couche photo active formée sur la couche empêchant la recombinaison ;
   une couche de transport de trous formée sur la couche photo active ; et
   une deuxième électrode formée sur la couche de transport de trous,
   dans laquelle la couche photo active est constituée d'une double couche de perovskite étant constituée d'une couche d'une première perovskite représentée par la formule chimique suivante 1 et d'une couche d'une deuxième perovskite représentée par la formule chimique suivante 2 formée sur la couche de première perovskite :

   [Formule chimique 1] $RMX_3$

   où, dans la formule chimique 1,

   R comprend a + 1 cations choisis dans le groupe constitué des cations $C_nH_{2n+1}NH_3^+$, où n est un nombre entier de 1 à 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, et de combinaisons de ceux-ci,
   M comprend a + 2 cations métalliques choisis dans le groupe constitué de $Pb^{2+}$, $Sn^{2+}$, $Ge^{2+}$, et de combinaisons de ceux-ci, et
   X est un anion halogénure ;

   [Formule chimique 2] $R'M'X'_3$

   où, dans la formule chimique 2,

   R' comprend a + 1 cations choisis dans le groupe constitué des cations $C_nH_{2n+1}NH_3^+$ où n est un nombre entier de 1 à 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, et de combinaisons de ceux-ci,
   M' comprend a + 2 cations métalliques choisis dans le groupe constitué de $Pb^{2+}$, $Sn^{2+}$, $Ge^{2+}$, et de combinaisons de ceux-ci, et
   X' est un anion halogénure ;
   **caractérisée en ce que** le cation R compris dans la formule chimique 1 et le cation R' compris dans la formule chimique 2 sont différents l'un de l'autre et le cation métallique M' est le même que M.

2. Cellule solaire en perovskite selon la revendication 1,
dans laquelle le cation R compris dans la première perovskite comprend un ion formamidinium, et le cation R' compris dans la deuxième perovskite comprend un cation méthyl ammonium.

3. Cellule solaire en perovskite selon la revendication 1,
dans laquelle une épaisseur de la couche de deuxième perovskite est inférieure ou égale à 300 nm.

4. Cellule solaire en perovskite selon la revendication 1,
dans laquelle la couche photo active comprend en outre une couche semi-conductrice.

5. Cellule solaire en perovskite selon la revendication 4,
dans laquelle la couche semi-conductrice a une structure poreuse comprenant des pores de 20 nm à 500 nm.

6. Cellule solaire en perovskite selon la revendication 1,
dans laquelle la couche de transport de trous comprend un matériau de transport de trous unimoléculaire ou polymérique.

7. Procédé de préparation d'une cellule solaire en perovskite, comprenant :

la formation d'une couche empêchant une recombinaison sur une première électrode comprenant un substrat conducteur transparent ;
la formation d'une couche photo active sur la couche empêchant la recombinaison ;
la formation d'une couche de transport de trous sur la couche photo active ; et
la formation d'une deuxième électrode sur la couche de transport de trous, dans lequel la formation de la couche photo active comprend le revêtement par une solution contenant une première perovskite représentée par la formule chimique suivante 1 sur la couche empêchant la recombinaison afin de former une couche de première perovskite, et le revêtement par une solution contenant un précurseur R'X' pour préparer une deuxième perovskite sur la couche de première perovskite afin de former une couche de deuxième perovskite représentée par la formule chimique suivante 2 de sorte à former une double couche de perovskite constituée de la couche de première perovskite et de la couche de deuxième perovskite:

$$[\text{Formule chimique 1}] \qquad RMX_3$$

où, dans la formule chimique 1,

R comprend a + 1 cations choisis dans le groupe constitué des cations $C_nH_{2n+1}NH_3^+$, où n est un nombre entier de 1 à 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH_4^+$, et de combinaisons de ceux-ci,
M comprend a + 2 cations métalliques choisis dans le groupe constitué des cations $Pb^{2+}$, $Sn^{2+}$, $Ge^{2+}$, et de combinaisons de ceux-ci, et
X est un anion halogénure ;

$$[\text{Formule chimique 2}] \qquad R'M'X'_3$$

où, dans la formule chimique 2,

R' comprend a + 1 cations choisis dans le groupe constitué des cations $C_nH_{2n+1}NH_3^+$, où n est un nombre entier de 1 à 9, $NH_4^+$, $HC(NH_2)_2^+$, $Cs^+$, $NF_4^+$, $NCl_4^+$, $PF_4^+$, $PCl_4^+$, $CH_3PH_3^+$, $CH_3AsH_3^+$, $CH_3SbH_3^+$, $PH_4^+$, $AsH_4^+$, $SbH4^+$, et de combinaisons de ceux-ci,
M' comprend a + 2 cations métalliques choisis dans le groupe constitué de $Pb^{2+}$, $Sn^{2+}$, $Ge^{2+}$, et de combinaisons de ceux-ci, et
X' est un anion halogénure ;
**caractérisé en ce que** la formation de la double couche de perovskite, après la formation de la couche de première perovskite par un revêtement avec une solution contenant la première perovskite sur la couche empêchant la recombinaison comprend le revêtement avec la solution contenant le précurseur R'X' pour préparer la deuxième perovskite sur la couche de première perovskite pour remplacer le cation R compris dans la première perovskite avec le cation R' compris dans le précurseur afin de préparer la deuxième perovskite de sorte à former la couche de deuxième perovskite sur la couche de première perovskite, où le cation R compris dans la formule chimique 1 et le cation R' compris dans la formule chimique 2 sont différents l'un de l'autre et le cation métallique M' est le même que M.

8. Procédé de préparation de la cellule solaire en perovskite selon la revendication 7, dans lequel le cation R compris dans la première perovskite comprend un ion formamidinium, et dans lequel le cation R' compris dans la deuxième perovskite comprend un cation méthyl ammonium.

9. Procédé de préparation de la cellule solaire en perovskite selon la revendication 7, dans lequel une épaisseur de la couche de deuxième perovskite est inférieure ou égale à 300 nm.

10. Procédé de préparation de la cellule solaire en perovskite selon la revendication 7, dans lequel la couche photo active comprend en outre une couche semi-conductrice.

11. Procédé de préparation de la cellule solaire en perovskite selon la revendication 10, dans lequel la couche semi-conductrice a une structure poreuse comprenant des pores de 20 nm à 500 nm.

12. Procédé de préparation de la cellule solaire en perovskite selon la revendication 7, dans lequel la formation de la couche photo active, après la formation de la double couche de perovskite incluant la couche de première perovskite et la couche de deuxième perovskite, comprend en outre un recuit de la couche photo active incluant la double couche de perovskite entre 100 °C et 170 °C.

13. Procédé de préparation de la cellule solaire en perovskite selon la revendication 10, comprenant en outre un recuit de la couche photo active incluant en outre la couche semi-conductrice entre 100 °C et 170 °C.

## FIG. 1A

## FIG. 1B

*FIG. 2*

*FIG. 3*

FIG. 4

EP 3 136 450 B1

EP 3 136 450 B1

## FIG. 5

jwl-1
pulse sequence : s2pu1

8.691

7.858

2.506
2.500
2.494

10  9  8  7  6  5  4  3  2  1  ppm

4.44  1.00

## FIG. 6A

*FIG. 6B*

## FIG. 6C

## FIG. 6D

## FIG. 6E

## FIG. 6F

*FIG. 7*

## FIG. 8

*FIG. 9A*

## FIG. 9B

*FIG. 9C*

## FIG. 9D

## FIG. 9E

FIG. 10A

FIG. 10B

FIG. 10C

## FIG. 10D

## FIG. 10E

## FIG. 10F

## FIG. 11

**(a)**

**(b)**

*FIG. 12A*

*FIG. 12B*

## FIG. 12C

## FIG. 12D

# FIG. 12E

FIG. 12F

## FIG. 13

## FIG. 14

$J_{SC}$ = 21.03 mA/cm$^2$

$V_{OC}$ =1.021 V

FF = 0.73

Efficiency = 15.77 %

*FIG. 15A*

*FIG. 15B*

(b) $HC(NH_2)_2PbI_3/CH_3NH_3PbI_3$

X 20,000    15.0kV SEI    SEM    1μm    SKKU    WD 6.0mm

## FIG. 16

FIG. 17A

## FIG. 17B

## FIG. 17C

*FIG. 18*

## FIG. 19

## FIG. 20A

FIG. 20B

FIG. 21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2693503 A1

**Non-patent literature cited in the description**

- *J. Am. Chem. Soc.,* 2009, vol. 131, 6050-6051
- *Sci. Rep.,* 2012, vol. 2 (579), 1-7
- *Inorg. Chem.,* 2013, vol. 52, 9019-9038
- *Energy Environ. Sci.,* 2014, vol. 7, 982-988